# EUROPEAN PATENT APPLICATION

(11) **EP 4 657 490 A2**
(43) Date of publication of application: **03.12.2025**
(21) Application number: 25188601.6
(22) Date of filing: 09.07.2025
(51) Int. Cl.: H01J 37/22, H01J 37/26

(54) **BEAM ALIGNMENT AND SYNCHRONIZATION IN MICROSCOPY**

(30) Priority: 10.05.2024 US 202463645747 P; 02.10.2024 US 202418904527
(71) Applicant: FEI COMPANY, Hillsboro, OR 97124 (US)
(72) Inventor: BONGIOVANNI, Gabriele, Eindhoven (NL); KIEFT, Erik, Eindhoven (NL)
(74) Representative: Boult Wade Tennant LLP

(57) **Abstract**

A method for aligning a pulsed laser beam in microscopy may include directing a first pulsed photon beam toward a target, directing a charged particle beam towards the target, determining a diffraction pattern resulting from an interaction of the charged particle beam with the target, directing a second pulsed photon beam towards the target, and determining a deviation of the diffraction pattern based at least in part on the second pulsed photon beam. In some embodiments, the method may include controlling, based at least in part on the deviation, a direction of pulsed photon emission by a light source, directing a third pulsed photon beam toward the target, generating detector data based at least in part on charged particles that result from a second interaction with the target and the third pulsed photon beam, and determining a position of the third pulsed photon beam, relative to the charged particle beam using the detector data.

## Description

### CROSS-REFERENCE TO RELATED APPLICATION

The present application claims the benefit of priority to U.S. Provisional Application No. 63/645,747, filed May 10, 2024, the entire contents of which are incorporated by reference herein for all purposes.

### TECHNICAL FIELD

Embodiments of the present disclosure are directed to charged particle microscope systems. More particularly, the present disclosure describes beam alignment and synchronization techniques in charged particle microscopy.

### BACKGROUND

Charged particle microscopy may be used for studying materials and structures that may be either biological or inorganic in nature. Scanning and transmission electron microscopes (SEM)/(TEM) form images by focusing a beam of electrons and/or photons onto a target such as a protein or a semiconductor wafer. Some particles may interact with the target and relay information about the target to a user of the microscope. Some microscopy techniques may additionally use laser-based techniques in conjunction with charged particle beams. When using laser based-techniques, relaxation time properties of the photoemitter, saturation effects, and residual emission are typically addressed by beam chopping methods. Using a chopper/beam blanker in the TEM, in turn, implicates active synchronization between two sources (the pump and the probe) that inherently each have their own clocks. Synchronization at the picosecond timescale presents significant challenges.

### BRIEF SUMMARY

According to certain embodiments, a method for aligning a pulsed laser beam in microscopy, the method may include directing a first pulsed photon beam toward a target, directing a charged particle beam towards the target, determining a diffraction pattern resulting from an interaction of the charged particle beam with the target, directing a second pulsed photon beam towards the target, determining a deviation of the diffraction pattern based at least in part on the second pulsed photon beam. In some embodiments, the method may include controlling, based at least in part on the deviation, a direction of pulsed photon emission by a light source, directing a third pulsed photon beam toward the target; generating detector data based at least in part on charged particles that result from a second interaction with the target and the third pulsed photon beam, and determining a position of the third pulsed photon beam, relative to the charged particle beam using the detector data.

In some examples, controlling the direction of pulsed photon emission may include determining a range of diffraction peaks of the diffraction pattern for the first pulsed photon beam, selecting a diffraction peak of the range of diffraction peaks, and measuring a first intensity of the diffraction peak when the first pulsed photon beam interacts with the target. In some embodiments, the method may include measuring a second intensity of the diffraction peak when the second pulsed photon beam interacts with the target, and calculating the deviation based at least in part on a comparison of the first intensity to the second intensity.

In some examples, the method may include generating a first position estimate of the second pulsed photon beam relative to the charged particle beam at the target based at least in part on the deviation, generating a second position estimate of the third pulsed photon beam relative to the charged particle beam at the target based at least in part on the detector data, and wherein the position may be determined based at least in part on a comparison of the first position estimate and the second position estimate.

In some examples, the method may include directing one or more subsequent pulsed photon beams towards one or more locations on the target, for each location of the one or more locations, capturing one or more diffraction images of one or more subsequent diffraction patterns, and determining, based at least in part on comparing the diffraction images, at least one position of the one or more subsequent photon beams relative to the charged particle beam.

In some examples, the method may include determining, based at least in part on the one or more subsequent diffraction patterns, a temperature profile of the target.

In some examples, the method may include directing one or more subsequent pulsed photon beams at one or more locations on the target until a fourth pulsed photon beam of the one or more subsequent photon beams is determined to be at a second position in a range of zero micrometers to one hundred micrometers to the charged particle beam at the target.

In some examples, determining the deviation of the diffraction pattern based at least in part on the second pulsed photon beam may include determining the deviation of an energy peak of the diffraction pattern based at least in part on the second pulsed photon beam.

In some examples, a non-transitory computer readable medium having stored thereon computer-readable instructions that, when executed by a processor, cause the processor to perform operations which may include directing a first pulsed photon beam towards a target, directing a charged particle beam towards the target; determining a diffraction pattern resulting from an interaction of the charged particle beam with the target, directing a second pulsed photon beam towards the target, determining a deviation of the diffraction pattern based at least in part on the second pulsed photon beam, and adjusting, based at least in part on the deviation, a direction of pulsed photon emission.

In some examples, the deviation includes a change in an intensity of a diffraction peak of the diffraction pattern, and wherein the operations may include in response to determining if the intensity has increased or decreased while the second pulsed photon beam is emitted towards the target, performing at least one of: directing a third pulsed photon beam towards a first location if the intensity has increased, directing the third pulsed photon beam towards a second location if the intensity has decreased, or determining that the second pulsed photon beam is in alignment with the charged particle beam.

In some examples, the operations may include redirecting the pulsed photon emission to reduce an intensity of one or more diffraction peaks of the diffraction pattern.

In some examples, in response to the deviation being within a threshold, determining that the second pulsed photon beam is aligned with the charged particle beam.

In some examples, the operations may include generating a first image of the diffraction pattern while the first pulsed photon beam is being emitted, generating a second image of the diffraction pattern while the second pulsed photon beam is being emitted, comparing the second image to the first image to generate a metric, and determining if one of the first pulsed photon beam or the second pulsed photon beam are in alignment with the charged particle beam at the target based at least in part on the metric.

In some examples, the operations may include generating a first image of the diffraction pattern at a first time, generating a second image of the diffraction pattern at a second time, determining an image difference between the first image and the second image, and in response to the image difference being less than a comparison threshold, determining a cooling rate of the target based at least in part on a difference of the first time and the second time.

In some examples, after the first pulsed photon beam is no longer being emitted toward the target and before the second pulsed photon beam is emitted, determining a temperature of the target, wherein the cooling rate is further based at least in part on the temperature of the target, and determining a repetition rate for the target based at least in part on the temperature remaining below a temperature threshold, wherein the repetition rate is equal to or less than the cooling rate.

In some examples, a method for aligning a pulsed laser beam in microscopy may include directing a first pulsed photon beam towards a target, directing a charged particle beam towards the target, generating detector data based at least in part on charged particles that have interacted with the target and that have corresponding energies within an energy range, and determining a position between the first pulsed photon beam and the charged particle beam at least partially based at least in part on the first image.

In some examples, prior to determining the position, switching an energy filter to an energy filtered mode to filter charged particles that have changed energy due to an interaction with the first pulsed photon beam, an imaging the charged particles which have changed energy, wherein the changed energy is measured relative to a zero loss peak, and in response to imaging, determining the position.

In some examples, the method may include adjusting an energy threshold of the energy filter, and in response to adjusting the energy threshold of the energy filter, determining a shape profile of the first pulsed photon beam at the target, or an intensity profile of the first pulsed photon beam at the target.

In some examples, the method may include determining a peak fluence of the first pulsed photon beam based at least in part on the shape profile or the intensity profile.

In some examples, prior to emitting the first pulsed photon beam, generating a first image of the target using the charged particle beam, after emitting the first pulsed photon beam, generating a second image of the target, and generating a profile image of the first pulsed photon beam by subtracting the first image from the second image.

In some examples, the method may include directing a direction of a second pulsed photon beam based at least in part on the position of the first pulsed photon beam and the charged particle beam at the target.
Further aspects of the invention are set out in the following numbered clauses:
1. A method for aligning a pulsed laser beam in microscopy, the method comprising:
   directing a first pulsed photon beam towards a target;
   directing a charged particle beam towards the target;
   determining a diffraction pattern resulting from an interaction of the charged particle beam with the target;
   directing a second pulsed photon beam towards the target;
   determining a deviation of the diffraction pattern based at least in part on the second pulsed photon beam;
   controlling, based at least in part on the deviation, a direction of pulsed photon emission by a light source;
   directing a third pulsed photon beam toward the target;
   generating detector data based at least in part on charged particles that result from a second interaction with the target and the third pulsed photon beam; and
   determining a position of the third pulsed photon beam, relative to the charged particle beam using the detector data.
2. The method of clause 1, wherein controlling the direction of pulsed photon emission further comprises:
   determining a range of diffraction peaks of the diffraction pattern for the first pulsed photon beam;
   selecting a diffraction peak from the range of diffraction peaks;
   measuring a first intensity of the diffraction peak when the first pulsed photon beam interacts with the target;
   measuring a second intensity of the diffraction peak when the second pulsed photon beam interacts with the target; and
   calculating the deviation based at least in part on a comparison of the first intensity to the second intensity.
3. The method of clause 1, further comprising:
   generating a first position estimate of the second pulsed photon beam relative to the charged particle beam at the target based at least in part on the deviation; and
   generating a second position estimate of the third pulsed photon beam relative to the charged particle beam at the target based at least in part on the detector data, wherein the position is determined based at least in part on a comparison of the first position estimate and the second position estimate.
4. The method of clause 1, further comprising:
   directing one or more subsequent pulsed photon beams towards one or more locations on the target;
   for each location of the one or more locations, capturing one or more diffraction images of one or more subsequent diffraction patterns; and
   determining, based at least in part on comparing the diffraction images, at least one position of the one or more subsequent photon beams relative to the charged particle beam.
5. The method of clause 4, determining, based at least in part on the one or more subsequent diffraction patterns, a temperature profile of the target.
6. The method of clause 1, further comprising:
   directing one or more subsequent pulsed photon beams at one or more locations on the target until a fourth pulsed photon beam of the one or more subsequent photon beams is determined to be at a second position in a range of 0 micrometers to 100 micrometers to the charged particle beam at the target.
7. The method of clause 1, wherein determining the deviation of the diffraction pattern based at least in part on the second pulsed photon beam comprises:
   determining the deviation of an energy peak of the diffraction pattern based at least in part on the second pulsed photon beam.
8. A non-transitory computer readable medium having stored thereon computer-readable instructions that, when executed by a processor, cause the processor to perform operations comprising:
   directing a first pulsed photon beam towards a target;
   directing a charged particle beam towards the target;
   determining a diffraction pattern resulting from an interaction of the charged particle beam with the target;
   directing a second pulsed photon beam towards the target;
   determining a deviation of the diffraction pattern based at least in part on the second pulsed photon beam; and
   adjusting, based at least in part on the deviation, a direction of pulsed photon emission.
9. The non-transitory computer readable medium of clause 8, wherein the deviation includes a change in an intensity of a diffraction peak of the diffraction pattern, and wherein the operations further comprise:
   in response to determining if the intensity has increased or decreased while the second pulsed photon beam is emitted towards the target, performing at least one of:
   directing a third pulsed photon beam towards a first location if the intensity has increased;
   directing the third pulsed photon beam towards a second location if the intensity has decreased; or
   determining that the second pulsed photon beam is in alignment with the charged particle beam.
10. The non-transitory computer readable medium of clause 8, wherein the operations further comprise:
   redirecting the pulsed photon emission to reduce an intensity of one or more diffraction peaks of the diffraction pattern.
11. The non-transitory computer readable medium of clause 8, wherein the operations further comprise:
   in response to the deviation being within a threshold, determining that the second pulsed photon beam is aligned with the charged particle beam.
12. The non-transitory computer readable medium of clause 8, wherein the operations further comprise:
   generating a first image of the diffraction pattern while the first pulsed photon beam is being emitted;
   generating a second image of the diffraction pattern while the second pulsed photon beam is being emitted;
   comparing the second image to the first image to generate a metric; and
   determining if one of the first pulsed photon beam or the second pulsed photon beam are in alignment with the charged particle beam at the target based at least in part on the metric.
13. The non-transitory computer readable medium of clause 8, wherein the operations further comprise:
   generating a first image of the diffraction pattern at a first time;
   generating a second image of the diffraction pattern at a second time;
   determining an image difference between the first image and the second image; and
   in response to the image difference being less than a comparison threshold, determining a cooling rate of the target based at least in part on a difference of the first time and the second time.
14. The non-transitory computer readable medium of clause 13, wherein the operations further comprise:
   after the first pulsed photon beam is no longer being emitted toward the target and before the second pulsed photon beam is emitted, determining a temperature of the target, wherein the cooling rate is further based at least in part on the temperature of the target; and
   determining a repetition rate for the target based at least in part on the temperature remaining below a temperature threshold, wherein the repetition rate is equal to or less than the cooling rate.
15. A method for aligning a pulsed laser beam in microscopy, the method comprising:
   directing a first pulsed photon beam towards a target;
   directing a charged particle beam towards the target;
   generating detector data based at least in part on charged particles that have interacted with the target and that have corresponding energies within an energy range; and
   determining a position between the first pulsed photon beam and the charged particle beam at least partially based at least in part on the detector data.
16. The method of clause 15, further comprising:
   prior to determining the position:
      switching an energy filter to an energy filtered mode to filter charged particles that have changed energy due to an interaction with the first pulsed photon beam; and
      detecting the charged particles which have changed energy, wherein the changed energy is measured relative to a zero loss peak; and
   in response to detecting, determining the position.
17. The method of clause 16, further comprising:
   adjusting an energy threshold of the energy filter; and
   in response to adjusting the energy threshold of the energy filter, determining a shape profile of the first pulsed photon beam at the target, or an intensity profile of the first pulsed photon beam at the target.
18. The method of clause 17, further comprising:
   determining a peak fluence of the first pulsed photon beam based at least in part on the shape profile or the intensity profile.
19. The method of clause 15, further comprising:
   prior to emitting the first pulsed photon beam, generating a first image of the target using the charged particle beam;
   after emitting the first pulsed photon beam, generating a second image of the target; and
   generating a profile image of the first pulsed photon beam by subtracting the first image from the second image.
20. The method of clause 15, further comprising:
   directing a direction of a second pulsed photon beam based at least in part on the position of the first pulsed photon beam and the charged particle beam at the target.

### BRIEF DESCRIPTION THE DRAWINGS

The foregoing aspects and many of the attendant advantages of the present disclosure will become more readily appreciated as the same become better understood by reference to the following detailed description, when taken in conjunction with the accompanying drawings.
FIG. 1 is an example schematic diagram illustrating an example charged particle beam system, in accordance with some embodiments of the present disclosure.
FIG. 2 is an example schematic diagram illustrating a system for controlling a pulsed light beam source and a pulsed charged particle source, in accordance with some embodiments of the present disclosure.
FIG. 3 is an example block flow diagram illustrating a technique for generating a control signal in system of a pulsed light beam source and a pulsed charged particle source, in accordance with some embodiments of the present disclosure.
FIG. 4 is an example schematic diagram illustrating a technique for gating a pulsed charged particle source using a control signal from a light beam source, in accordance with embodiments of the present disclosure.
FIG. 5 is an example composite diagram showing periodic operation of a beam blanker, in accordance with embodiments of the present disclosure.
FIG. 6 is an example schematic diagram illustrating a technique for interrogating a pulsed light beam using a pulsed charged particle beam, in accordance with embodiments of the present disclosure.
FIG. 7 is an example group of schematic diagrams illustrating example data for different pulsed light beam profiles, in accordance with embodiments of the present disclosure.
FIG. 8 is an example block flow diagram illustrating example processes for synchronizing and interrogating pulsed charged particle beams and pulsed light beams, in accordance with embodiments of the present disclosure.
FIG. 9 is an example block flow diagram illustrating example processes for synchronizing and interrogating pulsed charged particle beams and pulsed light beams, in accordance with embodiments of the present disclosure.
FIG. 10 is an example block flow diagram illustrating example processes for synchronizing and interrogating pulsed charged particle beams and pulsed light beams, in accordance with embodiments of the present disclosure.
FIG. 11 are examples of target interrogation systems of pulsed charged particle beam and pulsed light beam alignment structures, in accordance with embodiments of the present disclosure.
FIG. 12 is an example alignment process for aligning pulsed charged particle beams and pulsed light beams, in accordance with embodiments of the present disclosure.
FIG. 13 is an example diffraction peak image and intensity chart used for aligning pulsed charged particle beams and pulsed light beams, in accordance with embodiments of the present disclosure.
FIG. 14 is an example intensity chart depicting momentum transfer plotted by intensity, in accordance with embodiments of the present disclosure.
FIG. 15 is an example block flow diagram illustrating for aligning pulsed charged particle beams and pulsed light beams, in accordance with embodiments of the present disclosure.
FIG. 16 is an example system for aligning pulsed charged particle beams and pulsed light beams, in accordance with embodiments of the present disclosure.
FIG. 17 is an example system for identifying light beam spots for aligning pulsed charged particle beams and pulsed light beams, in accordance with embodiments of the present disclosure.
FIG. 18 is an example system for identifying light beam spots for aligning pulsed charged particle beams and pulsed light beams by changing an energy threshold of an energy filter, in accordance with embodiments of the present disclosure.
FIG. 19 is an example system for identifying light beam spot sizes, fluence of the light beam, and light beam profiles for aligning pulsed charged particle beams and pulsed light beams, in accordance with embodiments of the present disclosure.
FIG. 20 is an example block flow diagram illustrating for aligning pulsed charged particle beams and pulsed light beams, in accordance with embodiments of the present disclosure.
FIG. 21 is an example interrogation process for correcting target drift during and/or after aligning pulsed charged particle beams and pulsed light beams, in accordance with embodiments of the present disclosure.
FIG. 22 is an example imaging process for correcting target drift before, during, or after aligning pulsed charged particle beams and pulsed light beams, in accordance with embodiments of the present disclosure.
FIG. 23 is an example block flow diagram illustrating alignment of pulsed charged particle beams and pulsed light beams, in accordance with embodiments of the present disclosure.
FIG. 24 is an example process illustrating steps for alignment of a target and/or light beam during an example experiment as a function of time, in accordance with embodiments of the present disclosure.
FIG. 25 is an example block flow diagram illustrating a process for aligning pulsed charged particle beams and pulsed light beams, in accordance with embodiments of the present disclosure.
FIG. 26 is an example block system diagram, in accordance with embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been illustrated and described, it will be appreciated that various changes can be made therein without departing from the spirit and scope of the disclosure. In the forthcoming paragraphs, embodiments of charged particle beam systems, components, and methods to synchronize pulsed beams of photons and charged particles in systems including such subsystems. Embodiments of the present disclosure focus on transmission electron microscopes and related instruments in the interest of simplicity of description. To that end, embodiments are not limited to such systems, but rather are contemplated for charged particle beam systems configured for use in "ultrafast" techniques to probe sample dynamics on relatively short timescales (e.g., on the picosecond, femtosecond, etc., timescale). Advantageously, synchronization of pulsed light beam and charged particles can improve the performance of ultrafast microscopy techniques, at least in part by decoupling the light beam source from the charged particle source (e.g., by using an RF resonant cavity to generate a pulsed charged particle beam, rather than an optically pumped photoemitter). Further, independent control of the pulsed light beam and the pulsed charged particle beam permits a time delay to serve as an independent variable in various techniques for optical interrogation of materials (e.g., microresonators) as well as temporal characterization of the pulsed light beam itself.

In charged particle microscopy, characterizing various parameters of a target (e.g., a circuit, wafer, biological sample, etc.) may include interrogating the target with a charged particle beam such as an electron beam. The electrons may interact with the target and may be detected by a detector for analysis and review. Typically, the process of characterizing the target requires multiple cycles of pulsing the electron beam at the target to acquire images. As such, imaging in charged particle microscopes is typically based at least in part on elastic interactions of electrons with the target. These elastic interactions may have no gain or loss of energy and may provide information about structure and bonding of the target. Inelastic interactions, in contrast, do have energy loss due to electron excitations in the target and are investigated in electron energy loss spectroscopy (EELS). When imaging ultrafast structural dynamics, which may occur on a femtosecond timescale, light may be used to interrogate the target simultaneously with the electron beam by spatially overlapping a light beam with the electron beam at the target. For example, photon induced electron microscopy (PINEM) uses light in addition to the electron beam to interrogate the target to obtain images with high resolution in both the temporal and spatial domains. Aligning the light beam with the charged particle beam on the target has proven difficult and has conventionally required extended periods of trial-and-error, lengthy recalibration procedures, frequent adjustments of mirrors, targets, stages, or similar, which add significant time delays to experiments, increase damage to targets due to increased exposure, and limit resolution due to target drift, expansion, and/or heating. In addition to the aforementioned limitations of conventional systems, generation of photoelectrons (e.g., electrons ejected from the target irradiated by light) can be technically challenging and time consuming, the electron beam is typically sacrificed, and high-resolution capabilities of the microscope may remain largely unutilized.

According to embodiments described herein, a light source (e.g., laser) may emit a light beam which may be tightly synchronized, spatially and temporally, with electron arrival on the target after alignment of the light beam with the electron beam at the target. However, the light beam may not be initially aligned with the electron beam, or may lose alignment during the experiment. For example, as the target is irradiated with light and electrons, the target may intrinsically respond by heating, drifting, expanding, or similar. However, drift of the target does not necessarily always cause loss of alignment between the laser beam and the electron beam, as in some examples, drift of the mirrors as they warm up from the laser beam or due to temperature variations in the room, or drift of the laser source itself as it warms up, may cause drift.

In order to align and/or re-align the light beam and the electron beam on the target, some examples discussed herein make use of the Debye-Waller effect to use diffraction patterns as an excellent proxy for the light beam position on the target. For example, emitting electrons at the target may produce a diffraction pattern that may include several orders or "peaks" which may be analyzed. The Debye-Waller effect characterizes an intensity as a function of temperature. As the temperature of the target increases by way of partially absorbing some of the light from the light beam, the intensity of the peaks of the diffraction pattern created by the electron beam may generally decrease and "fan" out. As the target cools off, the intensity of the peaks of the diffraction pattern may generally increase and sharpen. By monitoring specific peaks of the diffraction pattern, the light beam may be translated across the target in order to characterize a position of the light beam relative to the static electron beam. As the light beam gets closer to the electron beam at the target, the intensity of the peaks will diminish. As the light beam gets farther away from the electron beam at the target, the intensity of the peaks will increase.

In some examples, the electron beam may be static relative to the light beam as the light beam scans the target. A user and/or machine learning algorithm may identify positions where peaks in the diffraction pattern are minimized and create a map showing that the light beam and the electron beam are aligned. Using this technique, aligning a light beam and electron beam on a target can be swift thereby reducing any potential damage to the target, reducing overall time required to perform experiments (e.g., PINEM/UFTEM experiments), and allows estimating the target's cooling rate. By estimating the target's cooling rate, a maximum repetition rate for a given target and/or experiment may be determined accurately, reliably, and repeatedly.

In some examples, aligning the light beam may additionally, or alternatively, include forming an image of a spatial profile of the light beam. For example, when the light beam interrogates the target, a surface field forms through which electrons from the electron beam may gain energy. By switching the microscope into an EELS mode to characterize electron energy gains, an energy filtered image may reveal a position, spatial profile (e.g., shape of the light beam), fluence estimations (e.g., flux), and/or intensity profile (e.g., how bright the light beam is) of the light beam on the surface of the target which is a significant technical improvement over conventional microscopes. By providing an image of the light beam, a user and/or machine learning algorithm may determine that the light source may include a flaw (e.g., manufacturer defect) resulting in a misshaped beam profile or intensity profile, a position of the light beam on the target within the microscope, defects of mirrors directing the light beam (e.g., surface profile defects), and/or structures that may be obscuring the light beam within the microscope, or similar. By identifying any of the aforementioned factors, the light beam may be visually aligned with the electron beam, the total time of the experiment may be significantly reduced, the reliability of the target data captured may be substantially improved, damage to the target may be minimized due to the reduction in experiment time, and the light source may be fully characterized.

In some examples, a detector may be synchronized with a beam blanker to monitor the target between exposures to the light beam and electron beam. As mentioned previously, aligning the light beam and electron beam may be difficult due to target drift, target expansion, and/or heating of the target. Conventionally, target drift has been an obstacle to obtaining high resolution images and is well known to adversely affect alignments procedures, and in addition, for targets where the electron beam and light beam are already aligned, the target moving by just a few nanometers may lead to blurring of an image (e.g., limiting image resolution). During conventional experiments, light beams may be pulsed while an electron beam interrogates a target. During periods where the light beam is "off" and not emitting at the target, the target cools off in preparation for the next capture cycle. This period between light beam pulses has conventionally been underutilized for any particular experiment, including alignment procedures. According to embodiments of the present disclosure, capturing extra images between light beam cycles using the electron beam may be used to monitor target drift, light beam alignment with the electron beam, and/or subsequently be used to correct for the target drift in a post-processing correction process. This technique provides a significant technical improvement over conventional microscopes in that a typically unused period of time between light beam shots is used to correct for target drift. By imaging the target between light beam shots, the target is still allowed to cool down from being heated by the light beams which may not affect the overall experiment.

Embodiments of the present disclosure include systems, methods, algorithms, and non-transitory media storing computer-readable instructions for synchronizing pulsed particle beams, such as electron beams and light beams, as well as interrogating pulse dynamics on the sub-microsecond timescale.

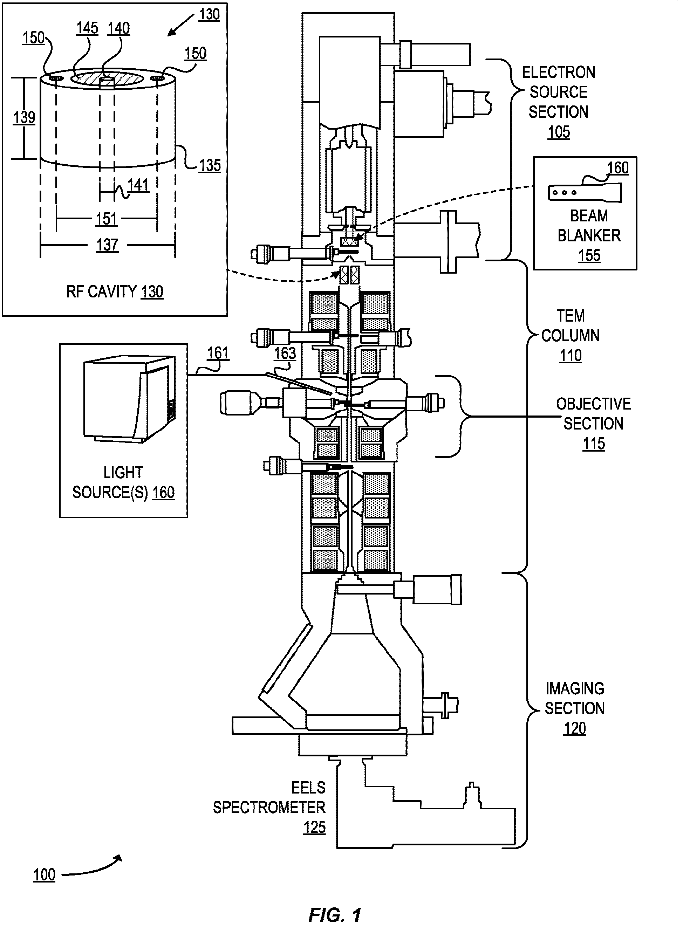

FIG. 1 is a schematic diagram illustrating an example charged particle beam system 100, in accordance with some embodiments of the present disclosure. In the following description, details of internal components and functions of the example TEM system 100 are omitted for simplicity and to focus description on embodiments of the present disclosure. The example TEM system 100 includes a charged particle source section, a TEM column including a sample section 105, a TEM column 110, an objective section 115, and an imaging section 120 (e.g., provided with an electron energy loss spectrometer 125). The example system 100 includes one or more components to enable "ultrafast" operation, such as a radio frequency (RF) cavity 130, a beam blanker 155, and one or more light beam sources 160. In the context of the present disclosure, "ultrafast" operation refers to a TEM system that is configured to generate detector data on the time scale of picoseconds, for example, through the use of pulsed beams for stroboscopic analysis. In this way, the relative position and sequence of the RF cavity 130 and the beam blanker 155 can vary in different embodiments of the present disclosure. For example, the RF cavity 130 can precede the beam blanker 155, and the components can be placed in different positions in the example system 100, in various approaches to producing a pulsed beam of electrons.

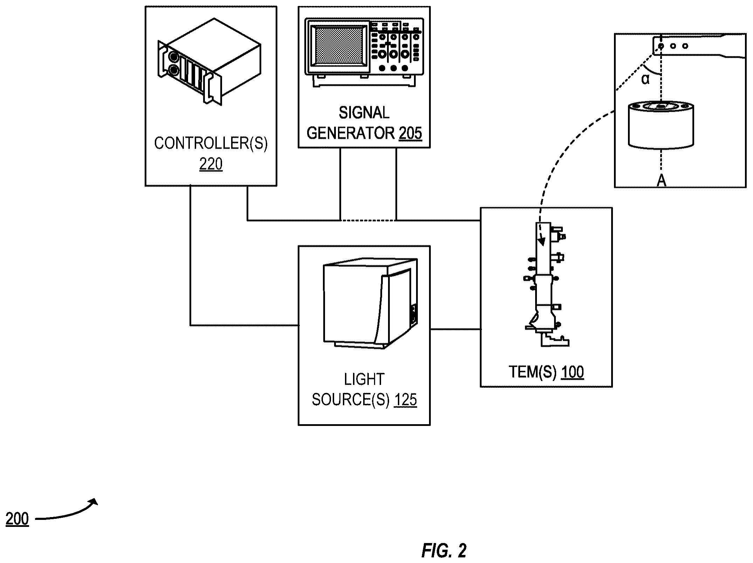

The charged particle source section 105 may include electronics configured to energize a source of charged particles, which can include a high-voltage field-emission source or other sources of emitted electrons, such that a beam of electrons is formed and conducted through a vacuum into the TEM column 110. The beam of electrons can be modulated using the beam blanker 155 to generate a train of pulses. The pulses can be generated by repeatedly deflecting the beam, in accordance with a trigger signal provided to the beam blanker, as described in more detail in reference to FIGs. 2-8. The beam blanker 155 can be an electrostatic element or an electromagnetic element. In some cases, a relaxation time of a magnetic field can limit the compatibility of an electromagnetic element with ultrafast operation. To that end, embodiments of the present disclosure may include an electrostatic beam blanker configured to periodically interrupt a continuous beam of electrons as an approach to generating a train of pulses characterized by a frequency from about one kilohertz (kHz) to about one hundred megahertz (MHz).

Downstream of the beam blanker 155, relative to the charged particle source section 105, the RF cavity 130 can be disposed such that the train of pulses pass through a body 135 of the RF cavity 130 via an aperture 140 defined in the body 135. The aperture 140 can be substantially centered about a beam axis of the example system 100, with the components of the RF cavity 130 being arrayed substantially symmetrically about the axis. The RF cavity 130 can include one or more antennas 150 disposed in the body 135. The antennas 150 can be electrically coupled with RF power circuits, and used to drive the antennas 150 at one or more RF frequencies. The antennas 150 can disposed in a dielectric or insulating insert 145, substantially concentric with the aperture 140. The behavior of the RF field in the aperture, such as the position of standing waves, can be based at least in part on the various distances 137, 139, 141, and 151 of the components of the RF cavity. For example, the distance 151 between the antennas 150 can influence the interaction of two RF fields in cases where each antenna may be driven at a respective RF frequency. The RF cavity 130 may be described in more detail in United States Patent US11328892B2, in European Patent EP3772745A3, and in Korean Patent KR102586724B1 and Korean Patent Application KR20230127968A, and in Japanese Patent JP7378366B2, entitled "Coating on dielectric insert of a resonant RF cavity," and in Chinese Patent CN112349571B, entitled "Radio frequency cavity and apparatus and system for use in charged particle microscopy," the disclosures of which are hereby incorporated by reference in their entireties.

The RF cavity 130 can be configured as a "dual mode" cavity, supporting two resonant modes at slightly offset field frequencies in the one to five gigahertz (GHz) range, including fractions, subranges, and interpolations thereof. The difference between the frequencies can result in a relatively lower frequency deflection of the charged particles over a downstream aperture (e.g., at about seventy-five MHz). The RF cavity 130 can include a pickup antenna, such that a second frequency at a harmonic of the relatively lower frequency can be derived from a signal from a pickup antenna inside the RF cavity. Advantageously, using the signal from the pickup antenna can reduce the effects of drift and instability in the RF cavity and associated drive circuitry, based at least in part on the signal for synchronization being derived from the actual field inside the RF cavity 130. In some cases, however, an electrostatic beam blanker with a bandwidth in the GHz range can be used with a single-mode RF cavity running from about one GHz to about five GHz (e.g., about 2.4 GHz). The beam blanker can directly modulate electron pulses of a 2.4 GHz sequence of pulses.

The TEM column 110 includes components for beam forming, including electromagnetic lenses and/or electrostatic lenses, and multiple apertures to control properties of the beam of electrons. TEM column 110 components include condenser lenses, objective lenses, projector lenses, aberration correctors, deflectors, stigmators, among others, as well as corresponding apertures. The objective section 115 hosts a sample through which a beam of electrons can be transmitted. The sample section can include one or more types of detectors, such as x-ray detectors, secondary electron detectors, etc.

The objective section 115 also includes an optical coupling 163 (e.g., by way of connector 161) with the light beam source(s) 160, by which photons can be introduced into the vacuum environment of the TEM system 100 and can be directed toward the sample. In some cases, the light beam source(s) 160 include a fiber laser. The light beam source(s) 160 can be coupled with the objective section 115 via an optical fiber. In some embodiments, the light beam source(s) 160 are optically coupled with the objective section 115 via one or more optical elements (e.g., optical mirrors, lenses, irises, filters, etc.). Similarly, embodiments of the present disclosure include systems in which the optical coupling 163 is included as part of the charged particle source section 105 or in the TEM column 110 other than the objective section 115. In this way, the example system 100 can include one or more optical elements disposed within the system to direct and transform a light beam toward the sample.

The light beam source(s) 125 can include a laser that includes an oscillator and an output stage. The oscillator can be configured to generate optical pulses at a given frequency that is characteristic of the design of the oscillator (e.g., about seventy-five MHz). The output stage can include an optical amplifier or other gain medium, which can also include a switch to determine which pulses are actually outputted from the oscillator (e.g., one in every N pulses from the oscillator). In this way, the switch can act as a "pulse picker" and the switching signal can act as a trigger signal, which can be used to modulate the beam blanker 155, as described in more detail in reference to FIGS. 2-5.

A state-of-the-art TEM column 110 can have as many as four condenser lenses for flexible (e.g., step-wise or graduated) demagnification and concentration of the electron beam on the sample, and as many as five projector lenses for flexible magnification of the electron beam downstream of the sample to the detectors, and as many as two aberration correctors. Since a state-of-the-art aberration corrector can comprise additional lenses and several multipoles (e.g., four lenses and two-three or more multipoles), a modern TEM column 110 can include up to about twenty lenses. Coordinated operation of the ensemble of lenses and other optical elements results in a given demagnification at the sample and magnification at the detector.

The imaging section 120 includes one or more types of detector, sensor, screen, and/or optics configured to generate images, spectra, and other data for use in sample imaging and/or microanalysis. For example, the imaging section can include a scintillator screen, binoculars, transmission electron microscopy (TEM) detector(s) (e.g., pixelated electron detector, secondary electron detector, camera(s)), segmented STEM detector(s), and electron energy loss spectroscopy (EELS) spectrometer(s) 125, among others. The EELS spectrometer 125 functions as an energy filter at least in part by focusing the beam of electrons onto an electrostatic or magnetic dispersive element (also referred to as a "prism") that applies a force on an electron that is proportional to the velocity of the electron. In this way, electrons that have transferred energy to or from the sample (e.g., by inelastic collision(s)) can be redirected through the magnetic dispersive element and toward a detector. The detector can include a pixelated detector (e.g., a CCD device configured to detect electrons) that generates one or two dimensional EELS data, from which EELS spectra can be derived. In some embodiments, EELS spectrometer(s) 125 also include one or more optical elements, such as electromagnetic or electrostatic lenses and/or multipoles and/or accelerators, to condition and/or focus the scattered electrons onto the detector.

Embodiments of the present disclosure relate to ultrafast electron microscopy in a TEM system, an example of which is described in reference to FIG. 1. FIGS. 2-10 concern techniques for improving the performance of a TEM system in ultrafast mode, including techniques for synchronizing an RF cavity (e.g., RF cavity 130 of FIG. 1) electron beam pulser to a laser system (e.g., light beam source(s) 125 of FIG. 1). A goal of the technique is to reliably phase-lock the laser signal and electron beam signal. Another goal is to achieve a controllable time delay between pump light beam pulses directed to a specimen in the TEM and electron pulses for probing the same specimen.

In the current art, which relies on a photoelectron emitter for laser-based ultrafast TEM, synchronization between a pump and a probe of the setup is achieved by an optical circuit that divides a light beam pulse into a pump pulse and a probe pulse, one of which is used to directly irradiate a sample, while the other is used to stimulate photoelectric emission, producing a synchronized pulse of electrons. Drawbacks of the laser-based techniques include relaxation time properties of the photoemitter, saturation effects, and residual emission that are typically addressed by beam chopping methods. Using a chopper/beam blanker in the TEM, in turn, implicates active synchronization between two sources (the pump and the probe) that inherently each have their own clocks. Synchronization at the picosecond timescale presents significant challenges.

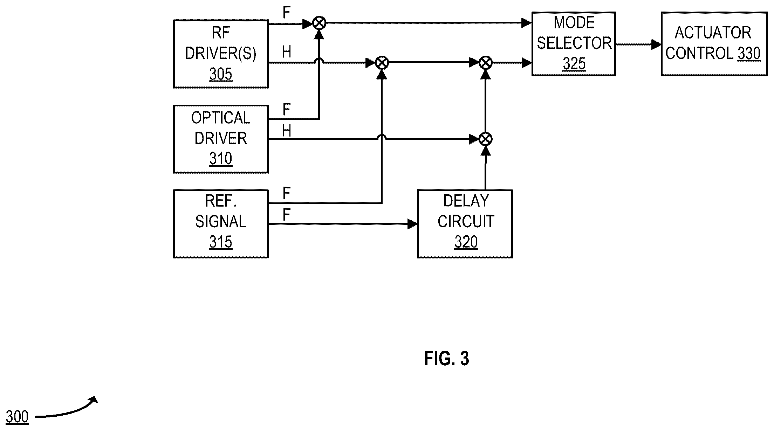

Embodiments of the present disclosure address challenges with synchronization at least in part by mixing signals coming from both sources, as illustrated in FIG. 3, thereby deriving a signal that scales with a time offset between the two signals, and in a control loop, adjusts the length of a laser oscillator (e.g., through one or more piezo positioners) to eliminate the time offset.

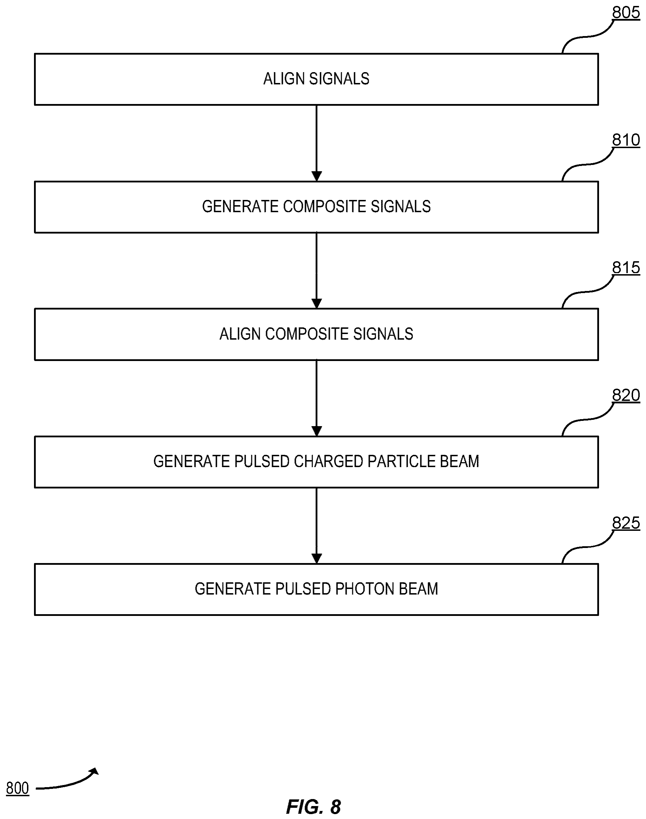

A detailed example of the techniques of the present example, as described in reference to FIG. 2 and FIG. 8, includes using an RF signal from the RF cavity module (e.g., RF driver(s) 305) to derive output signals for at least two frequencies, where the first frequency ("F" in FIG. 3) corresponds to a frequency of the laser oscillator and the second frequency is a harmonic ("H" in FIG. 3) of the first frequency. The example technique includes electronically mix both signals with corresponding signals from a laser system (e.g., optical driver 310). The example technique includes using the first (lower frequency) signal to define a coarse phase lock between the electron signal and the laser signal. As shown in FIG. 3, mixing the two signals at the first frequency can include a vector multiplication of the two signals to define an error signal, which can form the basis of a feedback control scheme including one or more parameters of the laser or the RF signal 315 as control variables.

Optimization of the error signal can be achieved through one or more control methods, such as, for example, a PID-style feedback control model using the error signal as the controlled variable and the characteristic length of the laser oscillator as the modulated variable, with a set point of zero for the error signal, within an allowable tolerance, for example. The optimization of the first error signal can correspond to a "coarse" synchronization of the laser and RF signals, after which the control techniques transition to the second frequency (H) signals for phase locking. In some embodiments, an electronic time delay is applied to one of the two higher-frequency signals (e.g., the RF harmonic signal or the laser/optical harmonic signal). An error signal can be generated using the two second frequency signals, of which one includes the time delay. The error signal can be used to generate a feedback signal to one or more piezos in the laser oscillator, so the oscillator output becomes locked to the RF signal 315. As shown in FIG. 3, a reference signal can be mixed with the second frequency (H) signals. Advantageously, one of the reference signals carries the electronic time delay (e.g., delay circuit 320). The reference signal can have a frequency from about one MHz to about one hundred MHz, including subranges, fractions, and interpolations thereof.

In some embodiments, the first frequency differs from the frequency of the field inside the RF cavity and/or or the frequency of the action of the cavity on the electrons. The first frequency can also be a submultiple of either. For example, the first frequency can be equal to the laser oscillator frequency but can also be a multiple of the laser oscillator frequency (e.g., in view of the discussion above, where a fast beam blanker is used to achieve an equal value for electron and optical pulse frequencies). In this case, the first frequency (F) can be a fraction of both the frequency of the field in the cavity and the frequency of the cavity-generated electron pulses (e.g., about seventy-five MHz).

In practice the synchronization can be achieved, using actuator control 330, at least in part by a) modifying a signal generator 205 (e.g., RF generator) to provide an additional synchronization output at about six hundred MHz, derived from the 2.4 GHz master oscillator signal, in addition to a seventy-five MHz synchronization signal; b) using a tunable pulsed laser module (e.g., light beam source 160), including synchronization controller 220 electronics; and c) connecting the RF sync outputs to the respective seventy-five MHz and six hundred MHz sync inputs of the controller 220 of the light beam source 160.

Advantageously, the techniques of the present disclosure obviate the need for an optical delay line in the laser path and provide nominally consistent light beam pulse properties on the sample. Further, implementing the systems 200, 300 as illustrated in FIG. 2 and FIG. 3 has little to no impact on the performance of the RF subsystem from the phase locking action. Additionally, the time delay can be electronically selected and/or defined, removing physical bounds on the length of the time delay that are imposed by a physical time delay optic (e.g., permitting potentially unlimited time delay not bound by a length of a delay line). Finally, the techniques of the present disclosure permit higher frequency locking for better accuracy, while also preventing phase ambiguity by starting from the base frequency of both systems, which can result in false convergence for a system with multiple stationary points.

While the general concept of RF to laser synchronization have been described, a significant limitation of existing methods is that time delay is introduced using an optical delay line. As such, a time delay is typically implemented in either of the branches (optical delay line or RF phase shifter). An optical delay line has the drawback that varying the delay inevitably has an impact on the positioning and/or focusing of the laser beam on the sample, implicating alignment and optical stability challenges. Likewise, a phase shifter in the RF signal path can negatively impact the amplitude and/or phase stability of the RF signal, implicating recalibration of internal components of the TEM system. Another drawback of some systems is the necessity for a deep integration between the laser system and the RF driver, limiting the flexibility of component selection which implicates, in turn, a dedicated TEM system, rather than a flexible ultrafast mode.

To that end, embodiments of the present disclosure include a "multi-mode" TEM system that includes an ultrafast mode using an RF cavity for beam chopping and a dual mode cavity (e.g., producing a beat frequency in the range of typical laser oscillators), and/or using a pickup antenna inside the RF cavity for producing the synchronization signal. In some embodiments, a pickup antenna inside the RF cavity is used to generate a synchronization signal directly from the actual standing wave of one of the modes in the cavity, thereby attenuating some sources of timing uncertainty in the RF module. This can be augmented using a higher harmonic second frequency (e.g., higher than six hundred MHz) for the fine phase locking (e.g., mode selector 325). For example, using a 1.2 GHz harmonic frequency can reduce variance in the error signal, additionally and/or alternatively to reducing instabilities in both types of signals, (e.g. using a more stable RF source), laser beam pointing correction (before it falls on a photodiode). The error signal can also be used to estimate instability between the RF and laser timings.

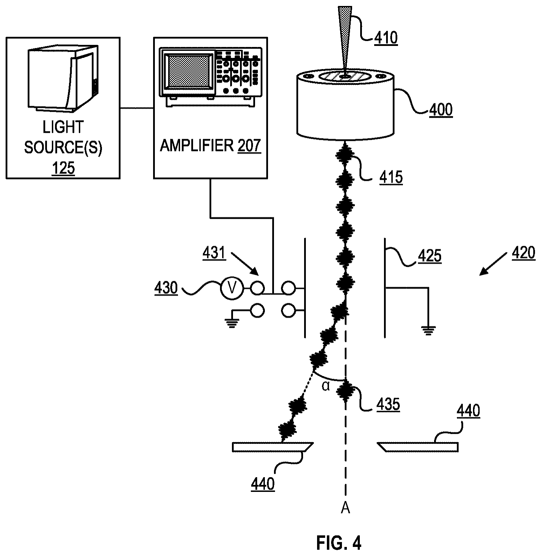

FIGS. 4-5 relate to ultrafast TEM in general, and to using an RF cavity-based electron beam pulser in combination with an amplified laser system, as described in more detail in reference to FIGS 1-3. In some cases, an amplified laser system will generate pulsed light beams at a given pulse rate, of which a subset of the pulses will be amplified. To that end, embodiments of the present disclosure enable pulsed particle beam systems to align the repetition rate of a pulsed charged particle beam with the amplified output of a pulsed laser system, at arbitrary repetition rates.

A resonant RF cavity 400 can operate at substantially fixed frequencies within a tuning range and may receive a charged particle beam 410. RF cavities can be synchronized with a light beam source 160, as described in more detail in reference to FIGS. 2-3, and can be adjusted such that the electron pulse frequency and light beam pulse frequency are synchronized to an arbitrary pulse frequency, across a relatively wide range of frequencies, through the application of an adjustable amplifier 207 (e.g., output stage) for the pulsed laser system and a beam blanker for the pulsed charged particle beam 415, as described in more detail in reference to FIG. 1.

To that end, a beam blanker 420 (e.g., beam blanker 155 of FIG. 1) can be used as a pulse picker, to sample a subset of pulses 435 generated by a resonant RF cavity 400. The beam blanker 420 can include electrodes 425, a voltage supply 430 coupled with the electrodes 425 via a high frequency switch 431 that can be coupled with the amplifier 207 of the laser system and/or via a common signal generator configured to generate a trigger signal to the laser amplifier and the switch 431. In this way, the beam blanker can be synchronized with a laser amplifier or shutter or have both the pulse picker and the laser amplifier or shutter synchronized to a common trigger signal.

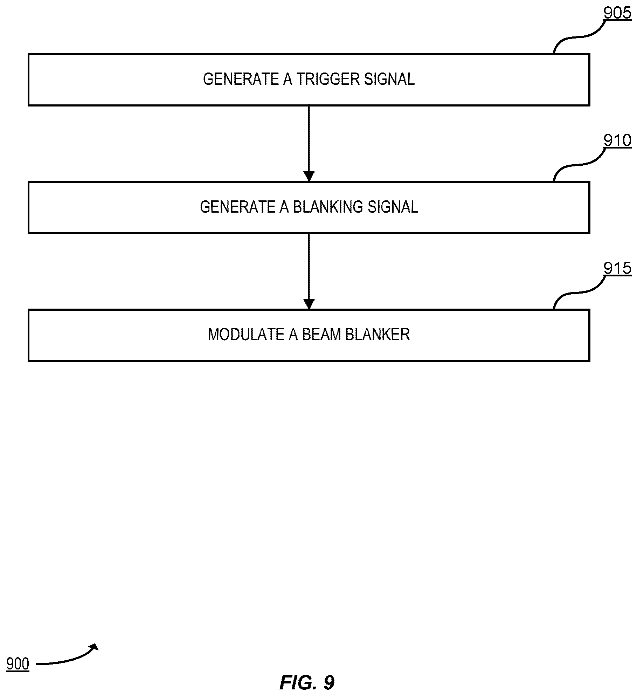

An example process (FIG. 9) includes generating a pulsed charged particle beam from a continuous electron beam using the RF cavity 400 or another high frequency beam modulator. The example process also includes using a high frequency beam blanker (e.g., an electrostatic beam blanker) or a second beam modulator as a "pulse picker." In this context, a "pulse picker" refers to the action of the optical element to periodically block the passage of electron pulses by deflecting pulses into a beam block, aperture 440, etc., in accordance with a trigger signal.

The example process also includes synchronizing the RF cavity synchronized to the laser oscillator as described in above and in reference to FIGS. 2-3. The RF cavity 400 can be configured to produce pulses at a repetition rate equal to or at a multiple of the laser oscillator frequency. The pulses can be subsampled by controlling the pulse picker (e.g., beam blanker 420) such that it opens at the same repetition rate as the amplified output of the laser, at that time letting through one or more pulses of electrons.

In typical femtosecond pulsed laser designs, the amplified laser output frequency is an exact sub-multiple of the oscillator frequency, such that exactly one in N pulses is amplified, where N is an integer larger than one. In this way, the laser amplifier and the pulse picker can be synchronized to a common trigger signal, but the pulse picker can also be synchronized to a signal from the laser. When the pulse picker is synchronized to the laser, an 'inverse' time delay variation can be applied to the pulse picker, to account for a time delay of the laser with respect to the RF signal. Advantageously, the 'inverse' time delay reduces or eliminates instability in the pulse picking.

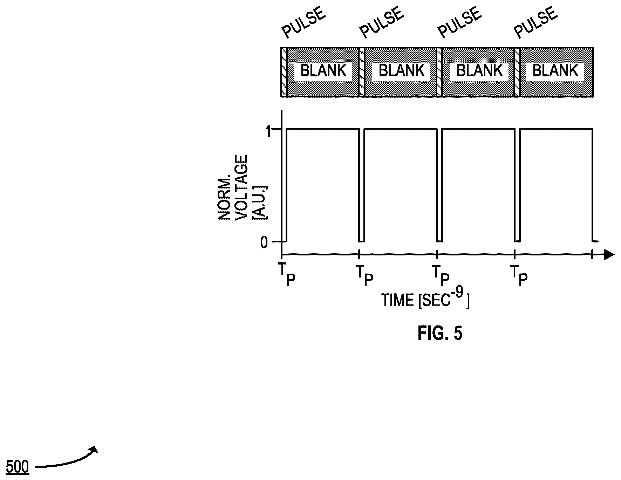

A time-delayed output 500 from a delay generator can be configured to trigger an Electrostatic Beam Blanker (ESBB) driver. The trigger signal can be synchronized with the amplifier and/or shutter of the laser, which allows using the amplified output of the laser at arbitrary submultiple frequencies. In some cases, as when accommodating hardware response time limitations, a trigger signal can unblank the beam blanker in time for the next laser pulse, which comes at a known period after the current one (FIG. 5). A time delay from about ten nanoseconds (ns) to about five hundred ns can improve temporal overlap between the 'picked' electron pulse and the light beam pulse on the specimen, although this time delay depends on a variety of experimental parameters. In some embodiments, the time delay can be about equal to a time between subsequent light beam pulses (e.g., about 9.07 microseconds for a pulse frequency of about 110.3 kHz), plus a fixed offset from about negative ten ns to about negative one thousand ns. This represents the "inverse time delay" where a positive delay is applied to beam blanker, but resulting in a negative time delay relative to the next laser pulse (e.g., next photon beam pulse). For long scan time delays, as the RF pulse is time delayed relative to the light beam pulse (e.g., a negative relative delay of the laser pulse), the ESBB time delay can be adjusted accordingly.

In this way, the time delay between RF and laser outputs can be delayed by a given value in time (e.g., positive), and an opposing (e.g., negative) time delay between the laser and the fast beam blanker can be applied, with the end result being to maintain the RF beam pulser and the beam blanker synchronization, while providing that the electron pulses and light beam pulses are time-shifted relative to each other.

Advantageously, embodiments of the present disclosure allow for a reduction of the repetition rate of electron pulses to an arbitrary frequency (e.g., as set by a laser system), while maintaining the pulse properties and timing accuracy of the RF cavity generated pulses. In contrast, the electron pulse frequency of conventional photoemission based ultrafast TEM is determined by the pulse frequency of the laser beam that is sent to the photocathode. Such techniques are limited by the challenges of an optical delay line as discussed in reference to the discussion above.

Within a relatively narrow range of the time delay between pulsed light beams and electron pulses, the time delay between laser and charged particle beam systems can be static. However, for large time delays, for example, on the order of the oscillator period, or larger, the pulse picker time delay can be 'scanned' relative to the laser signal, as part of controlling for "jitter" or other instability of RF generated electron pulses.

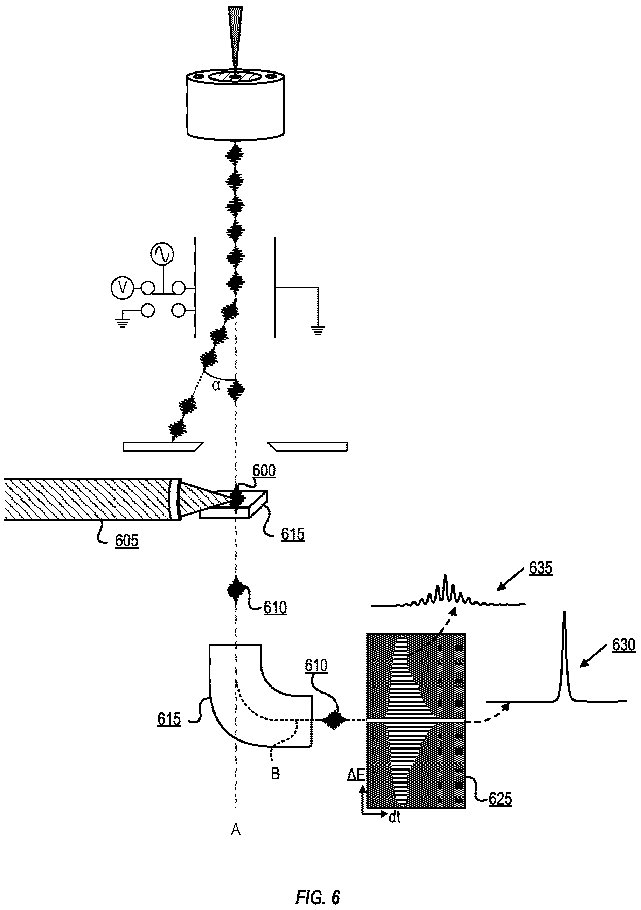

FIGs. 6-7 relate to ultrafast TEM in general, and to using an RF cavity-based electron beam pulser in combination with an amplified laser system, as described in more detail in reference to FIGs 1-5. In some cases, an amplified laser system will generate pulsed light beams with temporal pulse profiles 625, 700 that can be controlled based at least in part on the operating parameters of the laser system. To that end, embodiments of the present disclosure enable a pulsed charged particle beam to interrogate the temporal profile of the pulses being generated by the laser system.

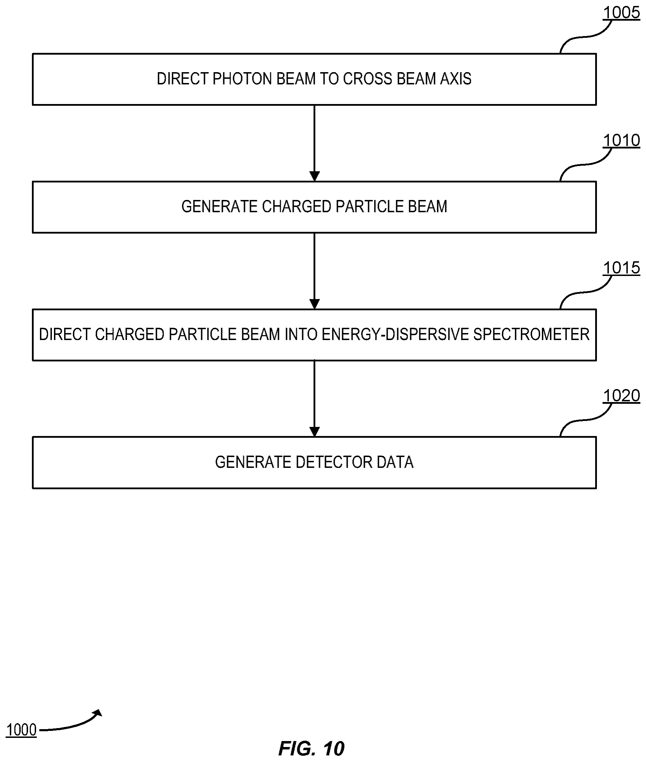

To that end, a process for interrogating a light beam pulse (FIG. 10) includes overlapping an electron pulse 600 with light beam pulses 605 on a sample 615, for example, in a TEM configured for ultrafast operation. Inelastic scattering of an electron beam through the light beam pulses 605 permits the pulse profiles 630, 635 to be derived over multiple pulse measurements, based at least in part on scanning a relative time delay to sample the pulse profile over a set of timesteps, using photon-induced near-field electron microscopy principles.

The PINEM method permits interrogation of time-varying nanoscale electromagnetic fields in an electron microscope, which is enabled on picosecond timescales using ultrafast TEM. For visible light, inelastic coupling between electrons and light is physically forbidden in free space, but is permitted by confining near-field radiation on a surface or nanostructure. In PINEM, confinement on the sample 615 generates evanescently confined near-fields with a broad momentum distribution, reaching high intensities in a nanoconfined space and thus also boosting the cross section of electron-light coupling. In this way, the processes of the current disclosure include recording a PINEM spectrum and scanning the time delay between electron and light beam pulses to record one or more additional spectra. Together, the PINEM spectra are used to measure the effective pulse duration of the laser pulse, and can be used to characterize the temporal intensity distribution of a pulsed laser. The method allows full characterization of the temporal profile of the laser intensity.

Conventionally, autocorrelators are used for characterizing ultrashort (e.g., picosecond to femtosecond scale) light beam pulses. A drawback of autocorrelators is that there is no 'sign' in the time scale; the output is always symmetric with respect to the peak intensity (i.e. time of maximum overlap). This limitation, which impairs the flexibility and robustness of the ultrafast systems, can be addressed by cross correlating the light beam pulse signal with a different signal, such as the electron pulse signal.

For example, the amplified output of a pulsed laser can be used for PINEM experiments. Where the laser system has a pulse compressor built into the amplified output path of the laser, variation of the final pulse duration from about one hundred femtoseconds (fs) to about one hundred picoseconds (ps) can be applied. Using time delay scans of the light beam pulses at various compressor settings, PINEM spectra of varying width can be collected as a function of relative time, representative of the intensity variation during the laser pulse. In contrast, autocorrelators that are commercially available and are capable of characterization of the temporal profile of light beam pulses always generate symmetric output, which lacks any information on the temporal asymmetry of the laser pulse. Advantageously, information about the asymmetry of the light beam pulse can improve accuracy and precision of microanalysis including ultrafast light beam pulse exposure. To that end, techniques of the present disclosure include processes for derivation of temporal intensity profiles of one or more light beam pulses, as well as pulse duration and laser chirp. Laser chirp, as an example, can be measured by varying peak separations in the PINEM spectra, as a function of time delay. Techniques of the present disclosure can be extended to applications in photonics and functional materials. In an illustrative example, an optically active material can be interrogated using the pulsed beam techniques described, as an approach to temporally characterize one or more optical modes in a microresonator. Optical modes include solitons or pulses that give rise to frequency combs. Measuring temporal characteristics of optically active materials relies on synchronization of electron pulses to the mode of the microresonator being interrogated, and can benefit from a relatively shortened pulse duration to improve temporal resolution of the mode shape.

FIG. 8 is an example block flow diagram illustrating example processes for synchronizing and interrogating pulsed charged particle beams and pulsed light beams, in accordance with embodiments of the present disclosure. In some examples, the process 800 may be implemented by some or all components of systems, devices, and/or include processes, methods, or techniques as those described in relation to FIGS. 1-7 and 9-26. In some embodiments, the process 800 may include more or fewer steps than the number depicted in FIG. 8. It should be appreciated that the steps may be performed in any suitable order. A process 800 begins at step 805 where aligning and/or synchronizing a pulsed electron beam with a pulsed photon beam occurs, as illustrated with respect to FIGS. 1-3. The process 800 can include synchronizing an RF signal and an optical pulse signal. The process 800 can include generating composite signals 810 using the RF signal, the optical pulse signal, and a reference signal. The process 800 can also include aligning and/or synchronizing the composite signals 815.

In some embodiments, the RF signal describes a frequency generated by an action of an RF cavity on a beam of electrons. The action of the RF cavity on the beam of electrons can include sweeping the beam of electrons 820 (e.g., pulsed charged particle beam) across an aperture placed in a path of the beam of electrons. A pulse frequency of the optical pulse signal (e.g., pulsed photon beam) 825 can be from about twenty five MHz to about one hundred and twenty five MHz.

In some embodiments, the RF signal and the optical pulse signal are frequency-matched. Frequency matched signals can correspond to a condition wherein a first harmonic frequency of the RF signal is substantially equal to a first harmonic frequency of the optical pulse signal.

In some embodiments, synchronizing the RF signal and the optical pulse signal include generating an error signal using a first harmonic frequency component of the RF signal and a first harmonic frequency component of the optical pulse signal. Synchronizing the RF signal and the optical pulse signal can also include modifying one or more parameters of a pulsed photon beam source, as part of an optimization of the error signal. Generating the error signal can include generating a vector-product of the RF signal and the optical pulse signal and filtering the vector-product to remove high frequency components of the vector-product. The high frequency components can include harmonic frequencies higher than the fundamental frequency component.

In some embodiments, the pulsed photon beam source is a pulsed laser source. The one or more parameters can include a characteristic length of a laser oscillator of the pulsed laser source. The characteristic length can describe a path length of the oscillator between two reflectors, with one or more of the reflectors being movable relative to a gain medium.

In some embodiments, generating the composite signals includes generating an RF composite signal, using a vector-product of a harmonic frequency component of the RF signal and the reference signal and generating an optical composite signal, using a vector-product of a harmonic frequency component of the optical pulse signal and the reference signal. The harmonic frequency can refer to a harmonic order higher than the first, or fundamental, frequency. Generating the optical composite signal can include adding a time delay to the vector-product of the harmonic frequency component of the optical pulse signal and the reference signal. The time delay can be a variable time delay.

In some embodiments, the reference signal has a frequency from about five MHz to about fifty MHz. Optionally, the frequency can be about twenty MHz.

In some embodiments, synchronizing the composite signals includes generating an error signal using the composite signals. Synchronizing the composite signals can also include modifying one or more parameters of a pulsed photon beam source, as part of an optimization of the error signal. Generating the error signal can include generating a vector-product of the RF composite signal and the optical composite signal and filtering the vector-product to remove frequency components of the vector-product outside a passband including the harmonic frequency component of the optical pulse signal and the harmonic frequency component of the RF composite signal.

FIG. 9 is an example block flow diagram illustrating example processes 900 for synchronizing and interrogating pulsed charged particle beams and pulsed light beams, in accordance with embodiments of the present disclosure. The process 900 may be implemented by some or all components of systems, devices, and/or include processes, methods, or techniques as those described in relation to FIGS. 1-8 and 10-26. In some embodiments, the process 800 may include more or fewer steps than the number depicted in FIG. 9. It should be appreciated that the steps may be performed in any suitable order. The process 900 can include generating a trigger signal 905. The processes 900 can include generating a blanking signal 910 using the trigger signal. The method can also include modulating a beam blanker 915 using the blanking signal.

In some embodiments, generating the trigger signal includes communicating a pulse signal from a pulsed photon beam controller to a delay generator. Generating the trigger signal can include receiving a control signal including timing information for the beam blanker and for a pulsed photon beam controller. Modulating the beam blanker can include temporarily quenching an electromagnetic field applied by the beam blanker, in the presence of which electrons are deflected away from a beam axis.

In some embodiments, generating the blanking signal includes combining the trigger signal with a delay offset. Generating the blanking signal can include receiving the delay offset from a control system. The delay offset can be an element in a set of offset data. Generating the blanking signal can include selecting the delay offset from the set of offset data in accordance with a process for interrogating a dynamic system.

In some embodiments, the trigger signal is characterized by a frequency from about 0.1 kHz to about ten MHz. The processes 900 can include synchronizing the pulsed electron beam and the pulsed photon beam by operations including synchronizing an RF signal and an optical pulse signal, generating composite signals using the RF signal, the optical pulse signal, and a reference signal, and synchronizing the composite signals.

In some embodiments, modulating the beam blanker temporarily unblocks the pulsed electron beam, permitting one or more pulses of electrons to pass the beam blanker substantially without deflection.

In some embodiments, the process 900 includes generating a pulse of photons using a pulsed photon source, concurrent with generating the trigger signal. The pulsed photon beam can be a pulsed laser. The beam blanker can be an electrostatic beam blanker.

FIG. 10 is an example block flow diagram illustrating example processes 1000 for synchronizing and interrogating pulsed charged particle beams and pulsed light beams, in accordance with embodiments of the present disclosure. The process 1000 may be implemented by some or all components of systems, devices, and/or include processes, methods, or techniques as those described in relation to FIGS. 1-9 and 11-26. In some embodiments, the process 1000 may include more or fewer steps than the number depicted in FIG. 10. It should be appreciated that the steps may be performed in any suitable order. The process 1000 can include directing a beam of photons to cross a beam axis 1005 of a charged particle beam system. The process 1000 can include generating a beam of charged particles 1010, the beam being substantially aligned with the beam axis. The process 1000 can include directing the beam of charged particles into an energy-dispersive spectrometer 1015 configured to generate detector data 1020 describing an energy distribution of the beam of charged particles. The process 1000 can also include generating a set of detector data, describing a plurality of energy distributions for a corresponding plurality of timesteps.

In some embodiments, the beam of charged particles is a pulsed beam and the beam of photons is a pulsed beam. The process 1000 can include synchronizing the beam of charged particles with the beam of photons. The process 1000 can also include defining the plurality of timesteps, where a timestep of the plurality of time steps can describe a temporal offset or phase delay of the beam of charged particles relative to the beam of photons.

In some embodiments, the beam of photons includes a pulse of photons defining a temporal profile. The method can include generating profile data using the set of detector data, the profile data describing the temporal profile. Generating the set of detector data can include sampling detector data generated concurrent with a period of interaction of the pulse of photons and the beam of charged particles. The detector data can be characterized by a sampling period about an order of magnitude smaller than a pulse duration described by the temporal profile. The method can include generating an operating parameter scheme corresponding to the temporal profile, the operating parameter scheme describing one or more operating parameters of the charged particle beam system.

In some embodiments, the beam of charged particles includes a pulse of charged particles. Generating the set of detector data can include integrating detector data for a given time step using multiple pulses of charged particles. The charged particles can be electrons. Directing the beam of photons to cross the beam axis can include coupling the beam of photons into an optically conducting material, the material being at least partially transmissive to the charged particles. The material can be disposed at least partially on the beam axis. The optically conducting material can include a photonic nanostructure, microresonator, or a photonic metamaterial.

In some embodiments, the charged particle beam system is an electron microscope. The electron microscope can be a transmission electron microscope (TEM). The electron microscope can include a radio frequency (RF) cavity, configured to generate a pulsed beam of charged particles having a pulse frequency from about twenty-five MHz to about one hundred MHz. Optionally, the pulse frequency can be about seventy-five MHz.

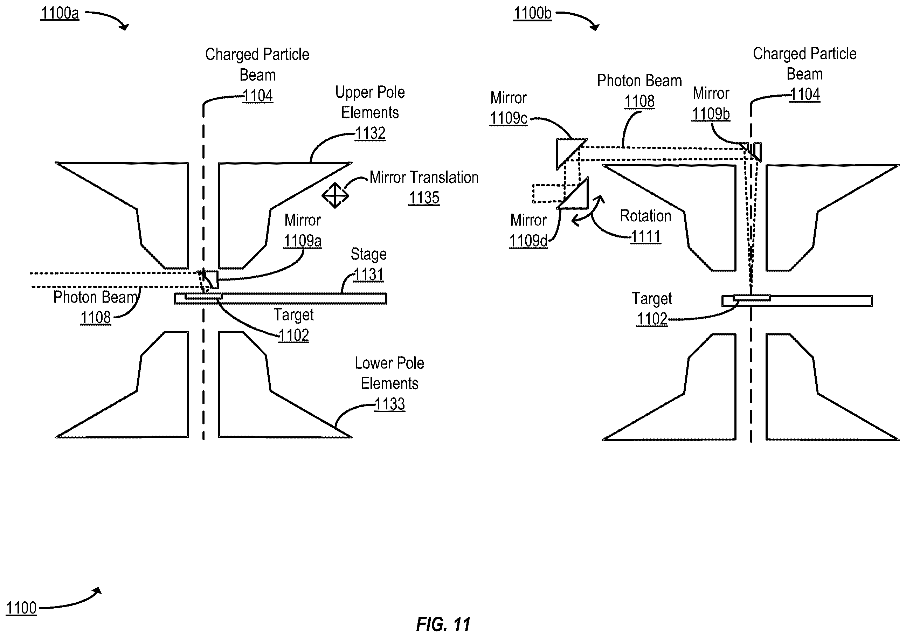

FIG. 11 are examples of target interrogation systems 1100 of pulsed charged particle beam and pulsed photon beam alignment structures, in accordance with embodiments of the present disclosure. In some examples, the examples of target interrogation systems 1100 may include some or all components of systems, devices, and/or perform processes, methods, or techniques as those described in relation to FIGS. 1-10 and 12-26. By way of example, the examples of target interrogation systems 1100 may include an example first optical arrangement 1100a which may include a mirror 1109a (e.g., a parabolic mirror) positioned above a target 1102 (e.g., wafer, circuit, protein, etc.) supported by a stage 1131 which may translate in at least one direction. The mirror 1109a may be supported by an arm (e.g., a long arm support) from a side that does not occlude or otherwise impact a charged particle beam 1104.

A light source (not depicted) may emit a pulsed photon beam 1108 (e.g., a collimated laser beam) along an axis towards the mirror 1109a and focused by the mirror 1109a onto the target 1102. A position and focus of the photon beam 1108 on the target may be changed by moving the mirror 1109 according to a mirror translation 1135 provided by a motor or similar. The mirror translation 1135 may move the mirror 1109a in an x-axis direction (e.g., left or right), a y-axis direction (e.g., in or out of the page), a z-axis direction (e.g., up or down), or may rotate the mirror 1109a along any one or more of the x-axis direction, the y-axis direction, or the z-axis direction. In some examples, the position and focus of the photon beam 1108 may move together the mirror 1109a. The first optical arrangement 1100a may include an objective lens which may include upper pole elements 1132 and lower pole elements in order to direct, contain, and focus the charged particle beam 1104 on the target 1102. In some examples, the mirror 1109a may be located within a microscope column (e.g., TEM column 110 of FIG. 1).

In some examples, the examples of target interrogation systems 1100 may include an example second optical arrangement 1100b which may include one or more mirrors 1109b, 1109c, 1109d. The mirrors 1110b-1109d may be flat, curved, parabolic, or combinations thereof. In addition, or alternatively, the mirrors 1110b-1109d may be located outside of the microscope column such that the pulsed photon beam 1108 (e.g., collimated, converging) may be relayed towards the target via mirrors 1109d, 1109c, and 1109b. In some examples, rotating one of the mirrors (e.g., mirror 1109d) along rotation 1111 may result in the pulsed photon beam 1108 moving across the target 1102. While three mirrors are depicted, it should be readily understood that any suitable number of mirrors may be used in any suitable configuration to relay the photon beam 1108 towards the target 1102.

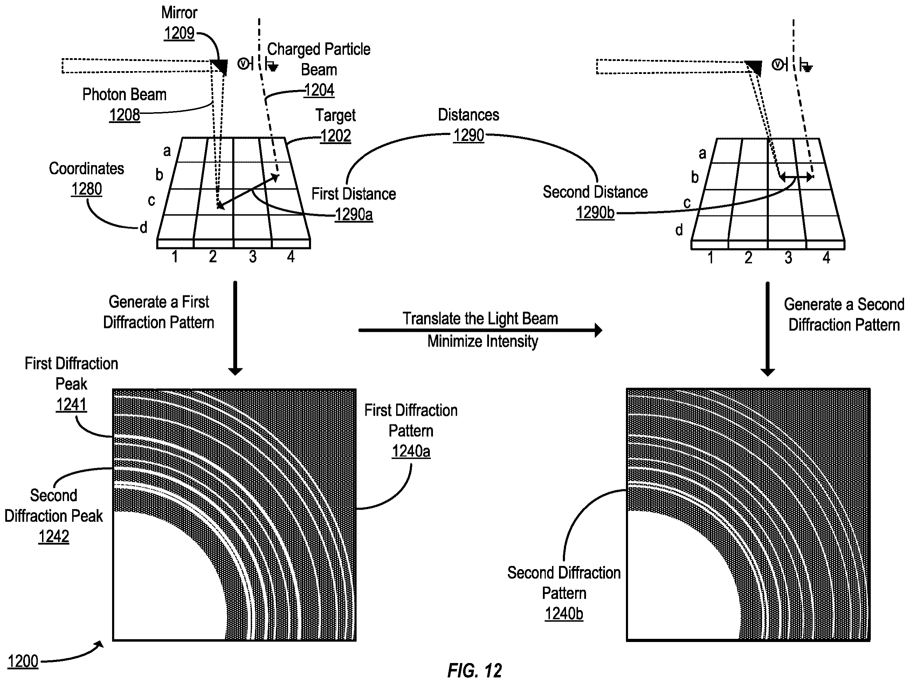

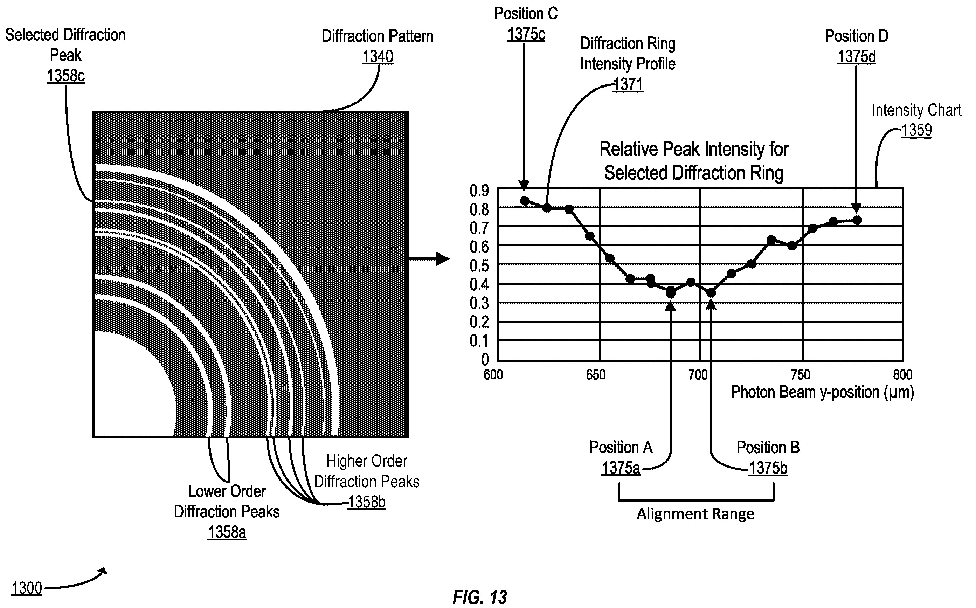

FIG. 12 is an example alignment process 1200 for aligning pulsed charged particle beams and pulsed photon beams, in accordance with embodiments of the present disclosure. In some examples, the alignment process 1200 may include some or all components of systems, devices, and/or perform processes, methods, or techniques as those described in relation to FIGS. 1-11 and 13-26. By way of a non-limiting example, the alignment process 1200 may use the Debye-Waller effect (discussed in more detail in FIG. 13) to align a photon beam 1208 (e.g., pulsed laser beam) with a charged particle beam 1204 (e.g., electrons). The photon beam 1208 may be directed by a mirror setup 1209 (e.g., mirrors 1109a-1109d of FIG. 11) towards a target 1202 (e.g., polycrystalline film). In some examples, the target 1202 may be a portion of a larger target and/or may include sections to be interrogated by both the photon beam 1208 and the charged particle beam 1204. In this example, the target 1202 has been divided into coordinates 1280 (e.g., c2, b4, d1, etc.) for clarity and ease of reference such that the letters a-d represent rows and the numbers one through four represent columns. The photon beam 1208 is shown to initially interrogate the target 1202 at a first coordinate c2 and the charged particle beam 1204 is shown to initially interrogate the target 1202 at a second coordinate b4. It should be noted that the target 1202 does not need to have any defined coordinate system and this process may be applied to any suitable arbitrary structure and/or material suitable for analysis.

In some examples, the photon beam 1208 may be directed onto the target 1202 during operation of a microscope. Due to changes during operation of the microscope (e.g., user defined, mechanical, new target installation, or similar), the photon beam 1208 may not be precisely aligned with the charged particle beam 1204 at the target 1202. For example, at the beginning of the alignment process 1200, the photon beam 1208 may be located at a first distance 1290a at the first coordinate c2 whereas the charged particle beam 1204 may be located at the second coordinate b4. By using the charged particle beam 1204 to interrogate the target 1202, a first diffraction pattern 1240a may be generated. The first diffraction pattern 1240a may include a set of diffraction peaks that may include a first diffraction peak 1241, a second diffraction peak 1242, and so on (e.g., orders of diffraction). It should be understood that while circular diffraction patterns are depicted for clarity and ease of understanding, one skilled in the art would readily recognize that any suitable diffraction pattern may be used such as diffraction spots, lines, or similar.

In some examples, due to the Debye-Waller effect, changes in distances 1290 between the photon beam 1208 and the charged particle beam 1204 result in changes to the diffraction patterns. For example, when the photon beam 1208 is farther from the charged particle beam 1204, the first diffraction peak 1241 may increase in a relative intensity. When the photon beam 1208 is closer to the charged particle beam 1204 on the target 1202, the first diffraction peak 1241 may decrease in relative intensity. By minimizing an intensity of selected diffraction peaks (e.g., as discussed in more detail in FIG. 13) by translating the photon beam 1208 (e.g., using mirrors 1109a-d), a position of the photon beam 1208 may be precisely determined. For example, when the photon beam 1208 is translated from position c2 to a position b3, with a second distance 1290b between the photon beam 1208 and the charged particle beam 1204, the intensity of a second diffraction pattern 1240b may decrease due to the second distance 1290b (e.g., distance between b3 and b4) being less than the first distance 1290a (e.g., distance between c2 and b4).

FIG. 13 is an example diffraction peak image and intensity chart 1300 used for aligning pulsed charged particle beams and pulsed photon beams, in accordance with embodiments of the present disclosure. In some examples, the diffraction peak image and intensity chart 1300 may be generated by some or all components of systems, devices, and/or a result of the processes, methods, or techniques as those described in relation to FIGS. 1-12 and 14-26. By way of a non-limiting example, a diffraction pattern 1340 may be generated by interrogating a target (e.g., target 1202 of FIG. 13) with a charged particle beam. By way of example a pulsed photon beam be scanned (e.g., discrete steps, continuously) across the target (e.g., across a y-axis of the target) at a number of positions which may locally heat the target in proximity to the position where the charged particle beam interrogates the target. As the target locally heats, the diffraction pattern 1340 may show intensity differences in one or more diffraction peaks 1358a-c. A detector (not depicted) may measure relative peak intensities at a number of positions (e.g., b1, b2, b3, b4, etc. of FIG. 12) to determine one or more optimal photon beam positions based at least in part on the relative peak intensities.

By way of the Debye-Waller effect, the closer the photon beam and the charged particle beam are to one another on the target, the dimmer and broader the diffraction peaks 1358 may become. The farther the photon beam and the charged particle beam are with respect to one another on the target, the brighter and narrower the diffraction peaks 1358 will become. Due to the Debye-Waller effect, the intensity differences for lower order diffraction peaks 1358a as the photon beam moves may be less substantial than intensity differences for higher order diffraction peaks 1358b (e.g., diffraction rings). An intensity chart 1359 illustrates relative peak intensities for a selected diffraction peak (e.g., selected diffraction peak 1358c) for a number of photon beam y-positions (e.g., mirrors 1109a-d position changes) across the target. For example, for positions from six hundred micrometers (µm) to eight hundred µm across the target, the relative peak intensity for the selected diffraction peak 1358c may vary (as measured by the detector) between 0.3 and 0.9 relative to a normalized intensity (e.g., user defined and/or pre-defined). For photon beam positions between position A 1375a and position B 1375b (e.g., between about six hundred and eighty µm and about seven hundred and ten µm), a range of positions having a minimum intensity may be identified.

In some examples, a specific diffraction peak may be selected for monitoring intensity. Higher order diffraction peaks (e.g., higher order diffraction peaks 1358b) are ideal choices due to having greater sensitivities to the photon beam than lower order diffraction peaks (e.g., lower order diffraction peaks 1358a). The specific diffraction peak may be selected by a user of the microscope or automatically by the microscope. For example, the user may identify an order of a diffraction peak that seems like a good candidate due to large variations in intensity as the photon beam traverses the target using a graphical user interface (GUI) (not depicted). When the microscope automatically determines the specific diffraction peak, the microscope may utilize one or more machine learning algorithms to determine the specific diffraction peak. For example, the machine learning algorithm may work with a controller (e.g., controller 2601 of FIG. 6) of the microscope to setup an initial position of the target, stage, photon beam, or charged particle beam. Once the microscope is set at an initial position, the microscope may begin an operation to emit the charged particle beam and photon beam (e.g., as described in FIG. 6) at the target.

Once the target is interrogated with the photon beam and charged particle beam, the detector may capture an image of the diffraction pattern. The machine learning algorithm may use one or more models (e.g., linear regression, image processing models, etc.) to identify one or more diffraction peaks of interest. For example, the machine learning algorithm may reposition the photon beam to a few locations to identify one or more diffraction peaks whose intensities appear to be more sensitive to the photon beam than others. In addition, or alternatively, the machine learning algorithm may determine an average and/or mean of intensities across the diffraction pattern 1340 in order to align the photon beam with the charged particle beam.

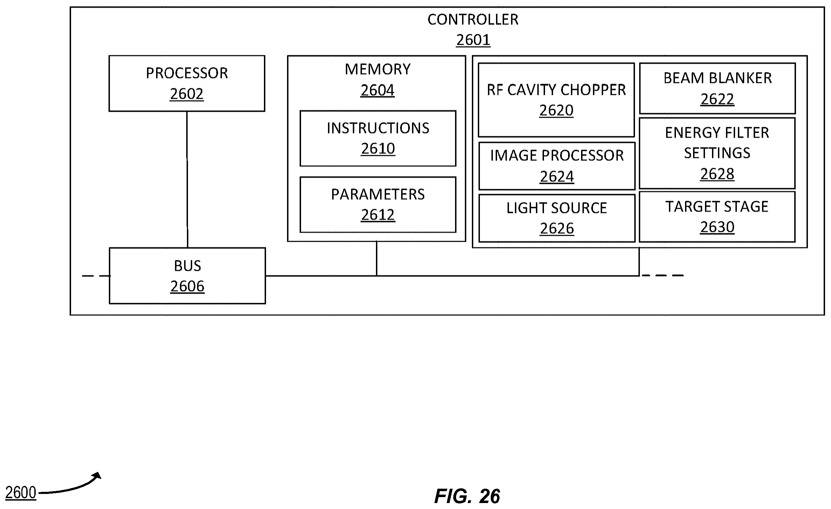

In some examples, the photon beam may be scanned across one or more coordinates of the target (e.g., coordinates 1280 of FIG. 12) such that some or all intensities for respective coordinates may be identified and stored in memory (e.g., memory 2604 of FIG. 26). For example, each dot along a diffraction peak intensity profile 1371 in the intensity chart 1359 may represent a respective measurement of intensity for the specific diffraction peak. After visiting each coordinate, the diffraction peak intensity profile 1371 may identify positions where the intensity of the diffraction peak is at its highest (e.g., position C 1375c and position D 1375d) and where the intensity of the diffraction peak is at its lowest (e.g., position A 1375a and position B 1375b). The user and/or controller of the microscope may store position A 1375a and position B 1375b as coordinates where the photon beam substantially overlaps the charged particle beam at the target due to the minimum relative intensities being around 0.35. While diffraction peaks are discussed herein, it should be understood that one skilled in the art would recognize that diffraction peaks may be substituted by any suitable diffraction pattern including diffraction lines, diffraction spots, or any suitable diffraction shape capable of intensity fluctuations. Additionally, or alternatively, a new diffraction pattern may be obtained by translating the charged particle beam and/or target (e.g., stage translation) and the processes may be repeated as desired.

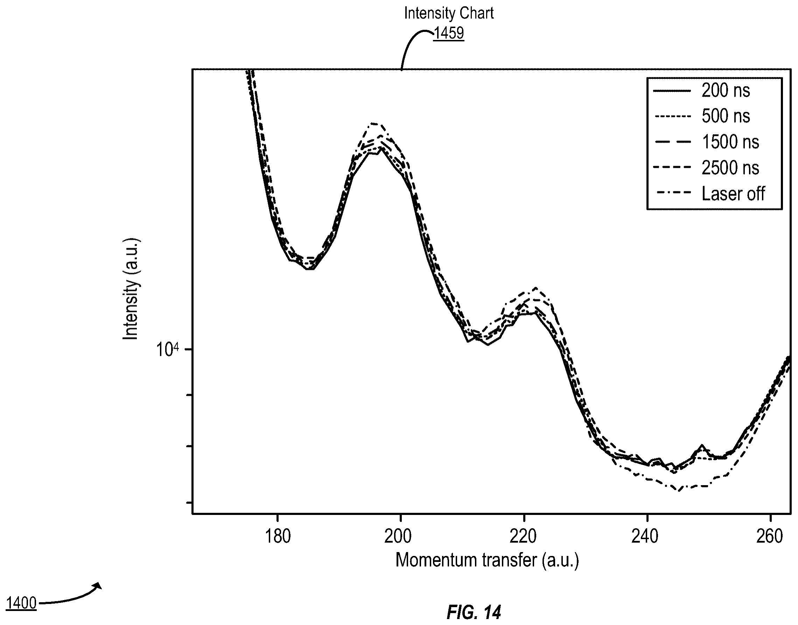

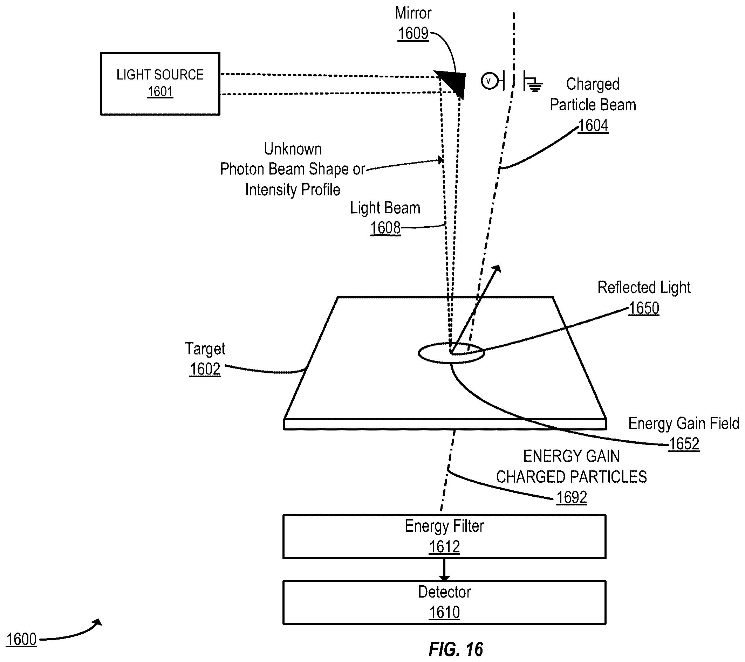

FIG. 14 is an example intensity chart 1400 depicting momentum transfer plotted by intensity, in accordance with embodiments of the present disclosure. In some examples, the intensity chart 1400 may be generated by some or all components of systems, devices, and/or a result of the processes, methods, or techniques as those described in relation to FIGS. 1-13 and 15-26. Each line in the intensity chart 1400 may depict an example intensity profile for one or more diffraction patterns which may be used to estimate a target cooling rate (e.g., a relaxation rate of the target) before, during, or after a photon beam alignment process. Determining the cooling rate of the target may aid in speeding up the alignment process and in addition, or alternatively, may speed up target acquisition times by determining how quickly acquisitions of the target may be repeated. For example, the charged particle beam may interrogate the target and generate one or more diffraction patterns (e.g., diffraction pattern 1340 of FIG. 13) and a detector (e.g., detector 1610 as depicted in FIG. 16) may capture an 'initial' relaxed state of the target to be used as a baseline image for future analysis.

According to some embodiments, each line in the intensity chart 1459 may represent an average intensity of peaks of diffraction patterns (e.g., intensity average along all points on a diffraction peak 1358c as depicted in FIG. 13). For example, from zero a.u. (e.g., for a position at a bottom left corner as depicted in diffraction pattern 1340 in FIG. 13) to over two hundred and sixty a.u., individual diffraction patterns (e.g., per intensity line) are represented as an absolute intensity spatially with two maxima and three minima depicted. The intensity chart 1459 may also include a laser 'off' curve (e.g., diffraction peak intensity when no photon beam is emitted on the target) illustrating an example baseline for determining repetition rates of the target.

According to certain embodiments, at a time after the photon beam was transmitted (e.g., two hundred ns), the charged particle beam may be pulsed at the target. A detector may capture an image of the target at this time. The capture may be repeated with successive photon beam pulses and charged particle beam pulses. During this process the target may begin to heat from the successive photon beam pulses and may cause the target to drift, expand, or similar. In order to account for changes in the target, a delay in the charged particle beam and photon beam may be implemented. For example, a delay of five hundred ns, 1500 ns, 2500 ns, etc. may be utilized to determine at which time delay may be adequate to allow the target to cool (e.g., relax) to the initial state so that further acquisitions may occur more quickly.

In addition, or alternatively, a controller (e.g., controller 2601) may determine that one or more first images acquired for a first delay t₁ are within a deviation threshold (e.g., differences in images are within ten percent, twenty percent, etc.) to one or more second images acquired for a second delay t₂. For example, if the first delay t₁ is five hundred ns and the second delay is 1500 ns, and the first images and second images are within the deviation threshold, the controller may determine that two MHz (e.g., 1/500 ns) may be the appropriate repetition rate for an experiment. By increasing a time delay after a light pulse, maxima of each diffraction peak may increase due to the target relaxing. For example, the intensity profile in momentum space for the laser off curve is closely matched to a delay of 2500 ns whereas the two hundred ns laser pulse is far from the laser off curve since the target has less time to cool off between pulses. In some examples, the controller may continually adjust the time delay of the charged particle beam and/or photon beam until an optimal repetition rate may be determined for the target. The optimal repetition rate (e.g., how quickly the experiment may be reperformed, or the highest repetition rate) for the target may then be stored in memory for future retrieval and/or training machine learning models.

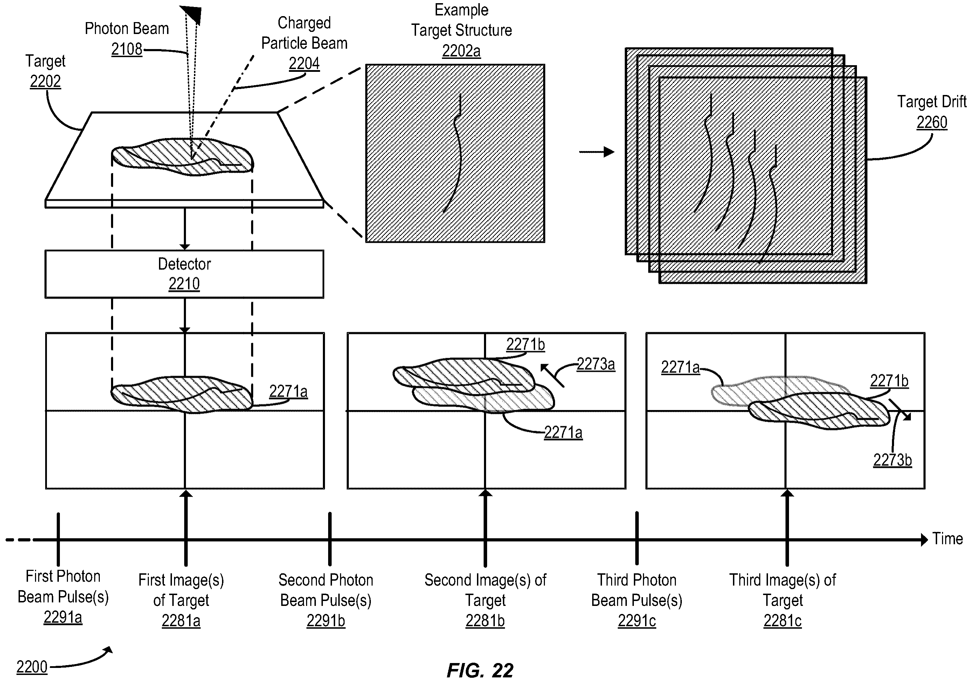

In some examples, a repetition rate may be determined from the relaxing rate. For example, when a user is performing an experiment on a target using the photon beam and the charged particle beam, the user must wait for the target to return to a relaxed state in order to collect more images of the target. However, for some targets, the relaxing rate may not be known initially and so collecting images too soon may introduce artifacts in images and be subject to target drift (discussed in detail in FIG. 22), among others. As such, the relaxing rate may be determined (as described above), as well as determining a temperature (e.g., by measuring relative intensities of the diffraction peaks and/or patterns) of the target. In some examples, the relaxing rate may be determined based at least in part on the time taken to relax to an initial state from an excited state as well as one or more temperature measurements of the target. The repetition rate for the target may be based, at least in part, on the relaxing rate, one or more images, and/or the temperature of the target remaining below a temperature threshold. The repetition rate for the experiment may be less than or equal to the relaxing rate. In a non-limiting example, the repetition rate may be between ten kilohertz (kHz) and one megahertz (MHz).

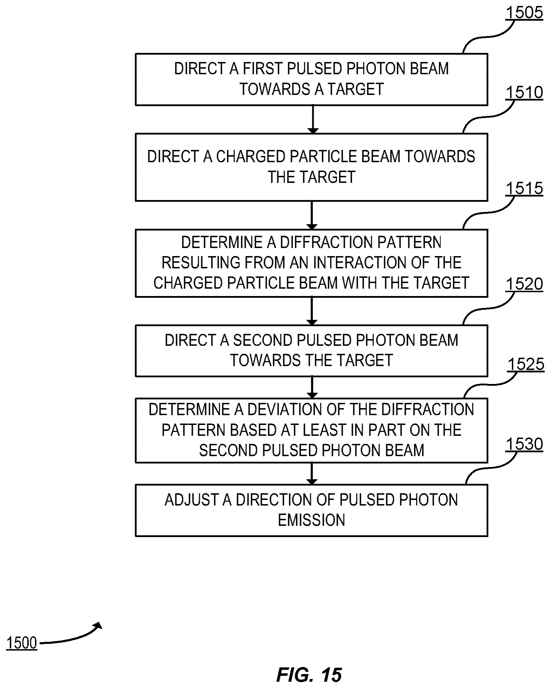

FIG. 15 is an example block flow diagram 1500 illustrating for aligning pulsed charged particle beams and pulsed photon beams, in accordance with embodiments of the present disclosure. In some embodiments, the flow diagram 1500 may include more or fewer steps than the number depicted in FIG. 15. It should be appreciated that the steps of the flow diagram 1500 may be performed in any suitable order. The flow diagram 1500 may be performed by some or all components of systems, devices, and/or include the processes, methods, or techniques as those described in relation to FIGS. 1-14 and 16-26.

The flow may begin at step 1505 where a light source may direct a first pulsed photon beam towards a target (e.g., target 1202 of FIG. 12). The light source may be a pulsed laser source or similar. In some examples, the light source may direct the first pulsed photon beam to an optical arrangement that includes one or more mirrors for changing a first location the first pulsed photon beam hits the target.

The flow may continue at step 1510 where a charged particle source (e.g., electron source) may direct a charged particle beam (e.g., electrons) towards the target while the first pulsed photon beam is emitted. In some examples, the charged particle beam may interact with the target at a second location, where the second location may be the same as the first location or may be different.

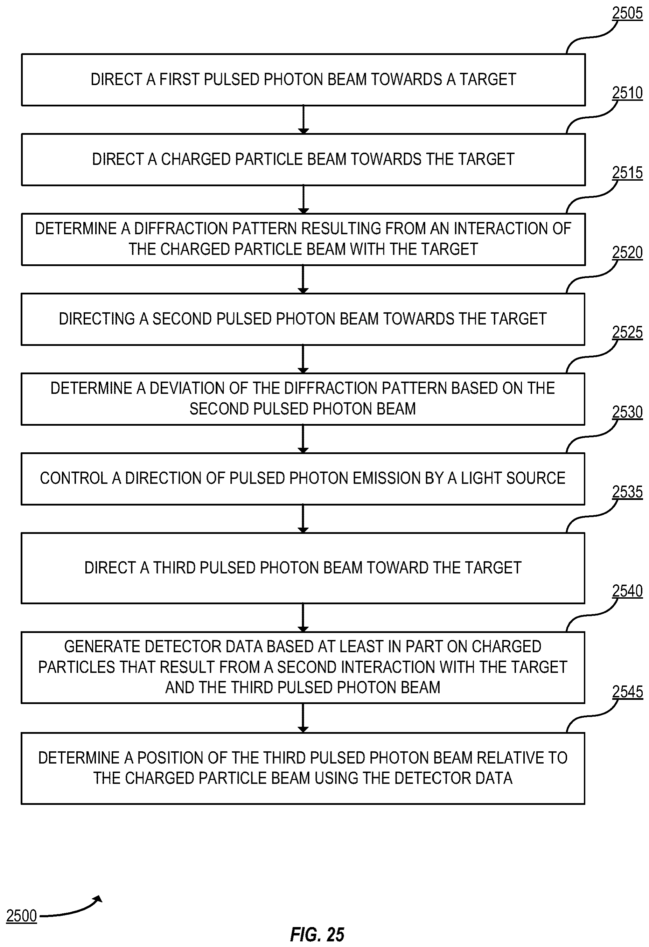

The flow may continue at step 1515 where a diffraction pattern is determined that may result from an interaction of the charged particle beam with the target. In some examples, the diffraction pattern may be a result of one or more structures of the target such as crystalline structures interacting with one of more charged particles of the charged particle beam. The diffraction pattern may be detected by a detector (e.g., CMOS, scintillator, etc.) and relayed to an image processor (e.g., image processor 2424 of FIG. 25) for processing.

The flow may continue at step 1520 where the light source may emit a second pulsed photon beam towards the target. For example, the light source may be configured to emit light intermittently at the target to let the target cool down in between diffraction pattern image captures (as discussed in FIG. 14). In addition, or alternatively, the second pulsed photon beam may be emitted at a third location, which may be different or the same as either or both of the first location or the second location.

The flow may continue at step 1525 where a deviation of the diffraction pattern may be determined based at least in part on the second pulsed photon beam. For example, when the second pulsed photon beam interrogates the target, the diffraction pattern may include one or more diffraction peaks that may deviate between successive pulsed photon beam interrogations. The deviation may include a change in intensity of the diffraction peaks. For example, if the intensity is determined to have increased or decreased while the second pulsed photon beam is emitted towards the target, one or more of the following processes may be performed: i) controlling the light source to emit a third pulsed photon beam towards a first new location if the intensity has increased, ii) controlling the light source to emit the third pulsed photon beam towards a second new location if the intensity has decreased, or iii) determine that the second pulsed photon beam is in alignment with the charged particle beam. In some examples, determining that the second pulsed photon beam is in alignment with the charged particle beam at the target may include the deviation being within a threshold such as a change in intensity between zero percent and twenty-five percent relative to the initial intensity.

The flow may continue at step 1530, where a direction of light emission from the light source may adjusted. For example, an optical arrangement which includes one or more mirrors (e.g., mirrors 1109a-d of FIG. 11) that adjust the direction of the pulsed photon beam to a new location on the target.

FIG. 16 is an example system 1600 for aligning pulsed charged particle beams and pulsed photon beams, in accordance with embodiments of the present disclosure. In some examples, the system 1600 may include some or all components of systems, devices, and/or perform processes, methods, or techniques as those described in relation to FIGS. 1-15 and 17-26. By way of a non-limiting example, the system 1600 may include a light source 1601 which may emit a photon beam 1608 towards one or more mirrors 1609 (e.g., mirrors 1109a-d of FIG. 11). The mirror 1609 may relay the photon beam 1608 towards a target 1602 (e.g., wafer, aluminum film, etc.). A charged particle source (not depicted) may emit a charged particle beam 1604 towards the target 1602. In some examples, the pulsed photon beam and charged particle beam may be emitted at the same time or at different times.

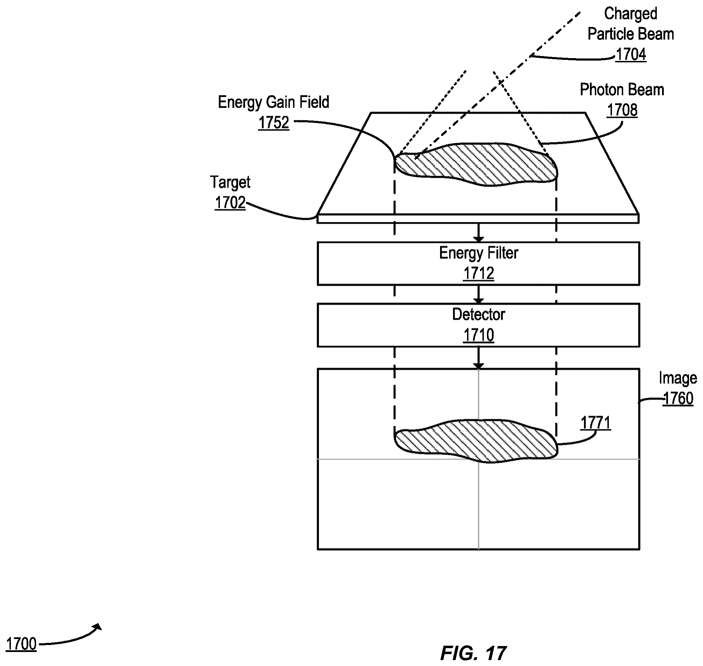

In some examples, the photon beam may reflect off a surface of the target 1602 such that an energy gain field 1652 may be generated. The charged particles from the charged particle beam that interact within the energy gain field 1652 may change energy (e.g., energy gain charged particles 1692) relative to a zero loss peak and may be imaged by a detector 1610. For example, an energy filter 1612 may function in an energy filtered transmission electron microscope (EFTEM) mode to filter out (e.g., block) charged particles which have not gained energy from energy gain charged particles 1692 (e.g., electrons which may have gained energy) to generate an energy filtered transmission electron microscopy image (e.g., energy gain filtered transmission electron microscopy (EGFTEM) image 1760 as described in more detail in FIG. 17). In some examples, and due to symmetry around a zero loss peak, energy gain (e.g., EGFTEM) and/or energy loss (e.g., energy loss filtered transmission electron microscopy (ELFTEM)) may be evaluated. Due to various configurations, manufacturing brands, and/or a large amount of commercially available light sources, parameters related to a photon beam shape, size, and/or an intensity profile of the light source 1601 may not be known prior to performing an experiment. The EGFTEM image may be used to determine those parameters and may include, but is not limited to, a location, size, an intensity profile, or beam profile of the pulsed photon beam at the target. The parameters may then be used to reliably align the photon beam with the charged particle beam by adjusting the location of the photon beam to coincide with the charged particle beam at the target based at least in part on the images. In addition, or alternatively, the charged particle beam, the target, and/or the stage supporting the target may be moved to align the photon beam 1608 with the charged particle beam 1604 at the target. In some examples, an off-axis mirror (e.g., parabolic mirror) may be used to create a tight focus of the photon beam 1608 on the sample to aid spatial alignment of the photon beam 1608.

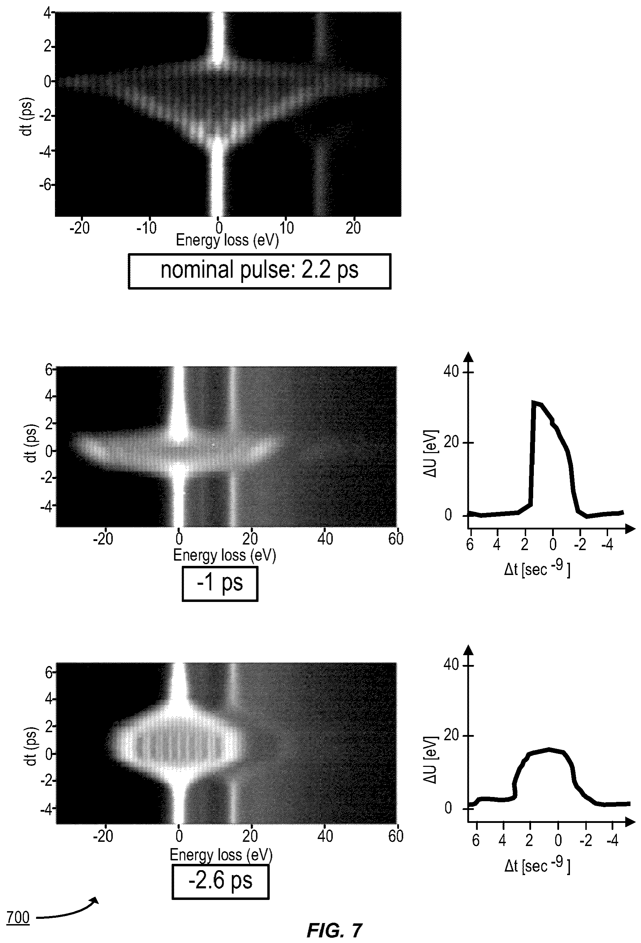

In some examples, a single photon-induced near-field electron microscope (PINEM) spectrum may include one or more energy peaks on either side of a zero loss peak (as mentioned above). The spacing between the energy peaks may be substantially equal to the photon energy (e.g., a spacing of 1.2 electron volts (eV)). The higher an intensity of the light source, the broader the total spectrum may become (e.g., as discussed in FIG. 7). Higher order peaks may become populated as a function of increasing the intensity of the light source as lower order energy peak intensities saturate and/or decrease in intensity. While operating in an EFTEM mode, a single energy gain order, multiple gain orders, or all orders above a certain number may be determined. For example, for a photon energy of 1.2 eV, a fifth PINEM order may be at six eV. To include the fifth PINEM order and/or all higher orders in an EGFTEM, a first edge of the energy filter 1612 may be defined at an energy gain of 5.4 eV (e.g., halfway between peaks of a fourth PINEM order and the fifth PINEM order) and a second edge at a sufficiently larger energy gain (e.g., thirty eV) to capture all higher orders that may be present in the spectrum. Due to unique saturation behaviors, a single EGFTEM image may not give linear representations of photon beam intensities on the target. In order to better approximate the intensity profile of the photon beam 1608, multiple EGFTEM images may be acquired. For example, each EGFTEM may cover one PINEM gain peak and/or profile (e.g., giving greater weights to higher orders as they correspond to greater photon beam intensities).

In some examples, it should be readily recognized by one skilled in the art that any suitable similar information (e.g., information from multiple EGFTEM images) may also be obtained by scanning the charged particle beam 1604 across the sample while recording a PINEM spectra at multiple scanning locations.

FIG. 17 is an example system 1700 for identifying photon beam spots for aligning pulsed charged particle beams and pulsed photon beams by changing an energy threshold, in accordance with embodiments of the present disclosure. In some examples, the system 1700 may include some or all components of systems, devices, and/or perform processes, methods, or techniques as those described in relation to FIGS. 1-16 and 18-26. By way of a non-limiting example, a photon beam 1708 may create an energy gain field 1752 on a target 1702. The charged particle beam 1704 may interrogate a location on the target 1702. The location the charged particle beam 1704 interrogates the target may or may not be spatially co-located with one or more areas of the energy gain field 1752. An energy filter 1712 may be switched into an EGFTEM mode by a user and/or by one or more preset settings for the system 1700 in order to record an EGFTEM image 1760, using a detector 1710, using charged particles (e.g., electrons) that may have substantially gained energy relative to a zero loss peak. The EGFTEM image 1760 may show a two dimensional beam profile 1771 of the pulsed photon beam 1708 on the surface of the target. Subsequently, a center location of the pulsed photon beam 1708 relative to the charged particle beam 1704 may be accurately determined by analyzing the center location (not depicted) of the two dimensional beam profile 1771 displayed in the EGFTEM image 1760 and viewed by the user using a GUI or similar.

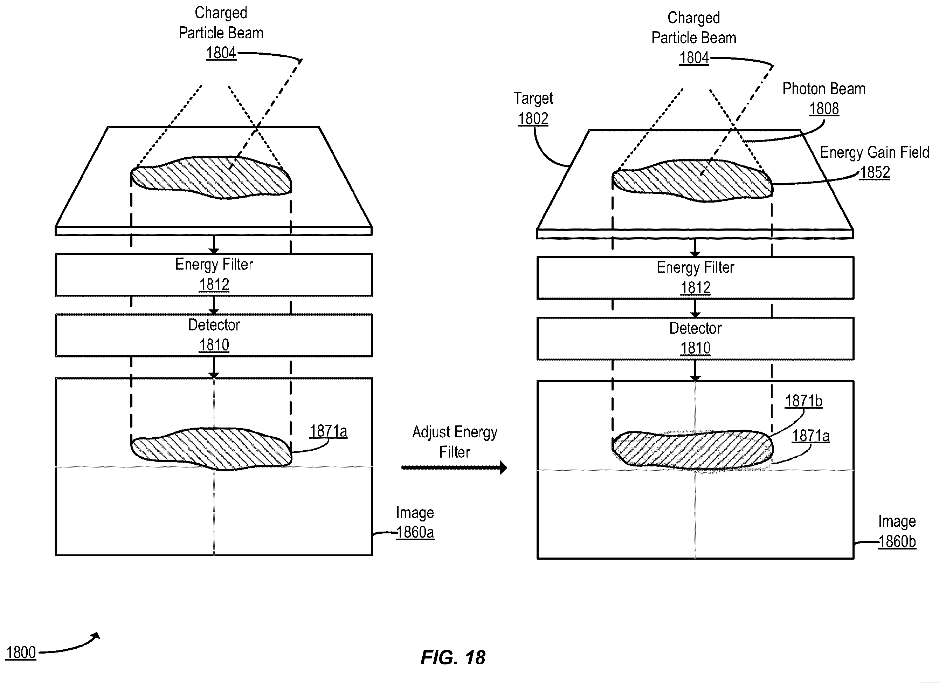

FIG. 18 is an example system 1800 for identifying photon beam spots for aligning pulsed charged particle beams and pulsed photon beams by changing an energy threshold of an energy filter, in accordance with embodiments of the present disclosure. In some examples, the system 1800 may include some or all components of systems, devices, and/or perform processes, methods, or techniques as those described in relation to FIGS. 1-17 and 19-26. By way of a non-limiting example, a pulsed photon beam 1808 may create an energy gain field 1852 on a target 1802. The charged particle beam 1804 may interrogate a location on the target 1802. The location the charged particle beam 1804 interrogates the target may or may not be spatially co-located with one or more areas of the energy gain field 1852 initially. Once a first EGFTEM image 1860a has been captured, a position of the pulsed photon beam 1808 to the charged particle beam 1804 may be determined. As such, the user and/or system 1800 may adjust the direction of the pulsed photon beam such that the pulsed photon beam may be co-located with the charged particle beam at the target. In some examples, an energy filter 1812 may be adjusted (e.g., changing an energy threshold) by a user and/or by one or more preset settings (e.g., energy filter settings 2628 of FIG. 26) for the system 1800 in order to record an EGFTEM image 1860b, using a detector 1810, using charged particles (e.g., electrons) that may have substantially gained energy relative to a zero loss peak.

The EGFTEM image 1860a may show a first two dimensional beam profile 1871b of the photon beam 1808 on the surface of the target which may differ from a second two dimensional beam profile 1871a that may have been captured prior to adjusting the energy filter 1812. For example, the first two dimensional beam profile 1871b may be a more detailed, accurate, and precise "image" of the photon beam at the target. Subsequently, a center location of the pulsed photon beam 1808 relative to the charged particle beam 1804 may be accurately determined by analyzing the location displayed in the EGFTEM image 1860b. In addition, or alternatively, by adjusting the energy filter 1812, the user and/or system may analyze a position (e.g., relative, absolute, etc.) of the pulsed photon beam relative to the charged particle beam, a beam shape, a size, an intensity, or a profile of the pulsed photon beam. It should be noted that the first two dimensional beam profile 1871b is shown to be super imposed on the second two dimensional beam profile 1871a to readily illustrate how the beam profile may be better defined by adjusting the energy filter 1812. In practice, the EGFTEM image 1860b may contain a relevant two dimensional beam profile without super imposed prior two dimensional beam profiles. However, it should be readily recognized by one skilled in the art that the EGFTEM image 1860b may contain one or more images of beam profiles of the pulsed photon beam on the target to help the user and/or image processor (e.g., image processor 2624 of FIG. 26) identify one or more of a beam shape, a size, an intensity, a profile, a change in beam shape, a change in size, a change in intensity, or a change in a profile of the pulsed photon beam. In addition, or alternatively, damage to the target may be identified.

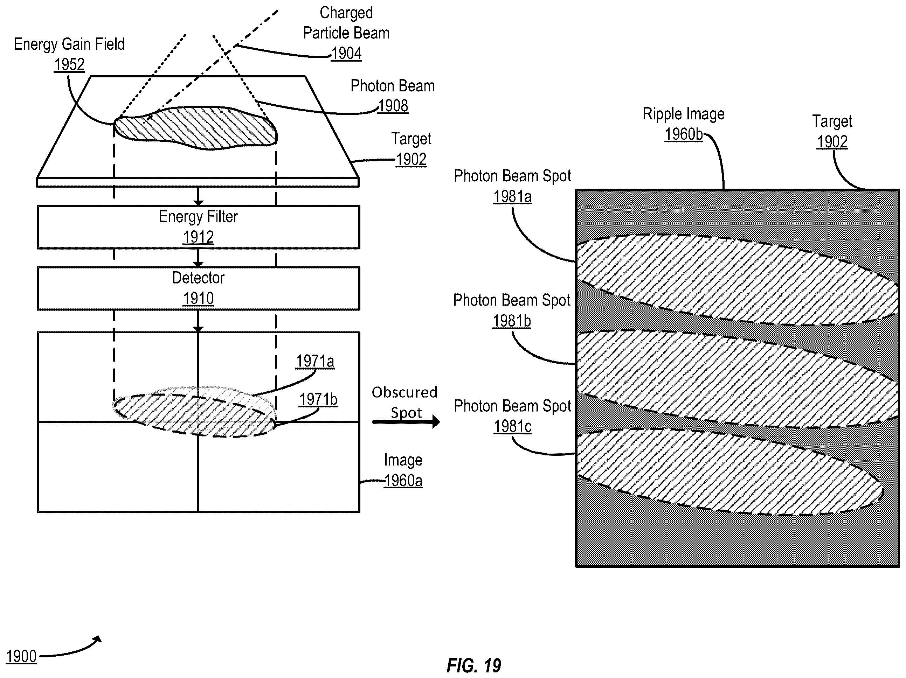

FIG. 19 is an example system 1900 for identifying photon beam spot sizes, fluence of the photon beam, and photon beam profiles for aligning pulsed charged particle beams and pulsed photon beams, in accordance with embodiments of the present disclosure. In some examples, the system 1900 may include some or all components of systems, devices, and/or perform processes, methods, or techniques as those described in relation to FIGS. 1-18 and 20-26. In some embodiments, prior to fine-tuning a spatial alignment of the pulsed charged particle beam and the pulsed photon beam, a photon-induced near-field electron microscope signal may be used in an electron energy loss spectrum (EELS) mode to confirm temporal alignment of the charged particle beam and photon beam. Subsequent to using the PINEM signal to temporally align the charged particle beam and the pulsed photon beam, an energy filter 1912 may be switched from EELS mode to EGFTEM mode for spatially aligning the pulsed photon beam and the charged particle beam. By way of a non-limiting example, a pulsed photon beam 1908 may create an energy gain field 1952 on a target 1902. The charged particle beam 1904 may interrogate a location on the target 1902. The location the charged particle beam 1904 interrogates the target 1902 may or may not be initially spatially co-located with one or more areas of the energy gain field 1852. An energy threshold of an energy filter 1912 may be adjusted by a user and/or by one or more preset settings (e.g., energy filter settings 2428 of FIG. 25) for the system 1900 in order to record an EGFTEM image 1960a, using a detector 1910, using charged particles (e.g., electrons) that may have substantially gained energy relative to a zero loss peak.

The EGFTEM image 1960a may show a first two dimensional beam profile 1971b of the pulsed photon beam 1908 on the surface of the target which may differ from a second two dimensional beam profile 1971a that may have been captured prior to changing the energy threshold the energy filter 1912. Subsequently, a center location of the pulsed photon beam 1908 relative to the charged particle beam 1904 may be accurately determined by analyzing the location displayed in the EGFTEM image 1960a (e.g., between zero µm and one hundred µm). In some examples, a minimum energy gain threshold may be adjusted for the energy filter 1912 such that multiple EGFTEM images may be captured representing increasing and/or decreasing intensities of the photon beam (not depicted). In addition, or alternatively, by adjusting the energy threshold of the energy filter 1912, the user and/or system may analyze a position of the photon beam 1908 relative to the charged particle beam, a beam shape, a size, an intensity, or a profile of the pulsed photon beam. It should be noted that the first two dimensional beam profile 1971b is shown to be super imposed on the second two dimensional beam profile 1971a to readily illustrate how the beam profile may change (e.g., obtaining a better resolution of what the beam profile actually looks like) by adjusting the energy threshold of the energy filter 1912. In practice, the EGFTEM image 1960a may contain a relevant two dimensional beam profile without super imposed prior two dimensional beam profiles. However, it should be readily recognized by one skilled in the art that the EGFTEM image 1960a may contain one or more images of beam profiles of the pulsed photon beam on the target to help the user and/or image processor (e.g., image processor 2624 of FIG. 26) identify one or more of a beam shape, a size, an intensity, a profile, a change in beam shape, a change in size, a change in intensity, or a change in a profile of the photon beam.

In some examples, a structure of the target 1902 and/or pulsed photon beam 1908 parameters may influence the EGFTEM image 1960. For example, for a particularly porous and/or coarse structure (e.g., dense nanowires, porous films, etc.), the pulsed photon beam's 1908 profile may distort anisotropically across the structure, especially when the pulsed photon beam 1908 is emitted at an angle not normal to a surface of the target 1902 which may generate visible artifacts such as "ripples" indicative of the pulsed photon beam 1908 being partly cut (obscured) along an optical path. For example, various components within the microscope and/or structures on the target may interrupt the optical path of the pulsed photon beam 1908 which may result in one or more photon beam spots 1981a-1981c, collectively "ripples". This may indicate to the user and/or system 1900 that the light source and/or pulsed photon beam 1908 may need to be adjusted, replaced, or realigned in order to obtain a unitary and/or substantially singular beam spot. In some examples, the user and/or system 1900 may identify that the pulsed photon beam 1908 is not generating a substantially singular projection but multiple projections (e.g., photon beam spots 1981a-1981c) based at least in part on the EGFTEM images. In this example, the user and/or system 1900 may perform one or more operations that may include, but are not limited to, i) adjust an optical arrangement of mirrors (e.g., mirrors 1109a-d of FIG. 11) to change a pulsed photon beam 1908 direction, ii) adjust a stage position that supports the target 1902, iii) adjust a charged particle beam source, iv) adjust a position and/or angle of the charged particle beam 1904, or similar.

Multiple EGFTEM images may be taken for multiple positions and/or angles of the pulsed photon beam 1908 relative to the charged particle beam in order to characterize the photon beam's 1908 parameters. For example, the EGFTEM images may have functions applied (e.g., cross-correlation, convolution, etc.) to add, subtract, and/or otherwise remove the structure of the target 1902 from the EGFTEM images. In some examples, removing the structure of the target 1902 may include capturing a baseline image (not depicted) of the target 1902 without the pulsed photon beam 1908 interrogating the target 1902. The baseline image may then be subtracted from the EGFTEM image 1960a to generate a filtered image which includes at least one first two dimensional beam profile 1971b. In some examples, the first two dimensional beam profile 1971b may be representative of a projection of the pulsed photon beam 1908 on the surface of the target 1902 generated by charged particles which have changed energy relative to a zero loss peak.

In some examples, an estimation of a fluence (e.g., peak fluence) of the pulsed photon beam 1908 may be calculated. For example, the user and/or system 1900 may capture one or more EGFTEM images 1960a in order to generate a filtered image that may include the first two dimensional beam profile 1971b. The fluence of the pulsed photon beam 1908 is a measure of an optical energy of the photon beam 1908 for a given surface area. In this example, an intensity of the first two dimensional beam profile 1971b may be calculated based at least in part on one or more EGFTEM captures and performing a comparison of intensity changes as the pulsed photon beam 1908 aligns with the charged particle beam 1904 on the target 1902 across various positions on the target. The fluence may be calculated by measuring an area of either first/second two dimensional beam profile 1971a/b and dividing the intensity of either of the first/second two dimensional beam profile 1971a/b by the area, respectively.

In some examples, one or more photon beam spots may be selected for monitoring intensity of the pulsed photon beam 1908 on the target 1902 as the pulsed photon beam 1908 is aligned to the charged particle beam 1904 on the target 1902. The photon beam spots may be selected by a user of the microscope or automatically by the microscope. For example, the user may identify an initial photon beam spot that seems like a good candidate for alignment due to having a good shape and intensity (e.g., substantially unitary shape with high EGFTEM image contrast). In addition, or alternatively, when the microscope automatically determines a good candidate, the microscope may utilize one or more machine learning algorithms to determine select a specific photon beam spot. For example, the machine learning algorithm may work with a controller (e.g., controller 2601 of FIG. 26) of the microscope to setup an initial position of the target 1902, stage, photon beam 1908, or charged particle beam 1904. Once the microscope is set at an initial position, the microscope may begin an operation to emit the charged particle beam 1904 and pulsed photon beam 1908 (e.g., as described in more detail in FIG. 6) at the target 1902. Once the target 1902 is interrogated with the photon beam 1908 and charged particle beam 1904, the detector 1910 may capture an image of the photon beam spot (e.g., first two dimensional beam profile 1971b). The machine learning algorithm may use one or more models (e.g., linear regression, image processing models, etc.) to identify one or more the photon beam spots of interest. For example, the machine learning algorithm may reposition the pulsed photon beam 1908 to a few locations to identify one or more photon beam spots whose shapes and/or intensities appear are readily identifiable. In addition, or alternatively, the machine learning algorithm may determine an average and/or mean of intensities across the photon beam spots in order to align the photon beam 1908 with the charged particle beam 1904.

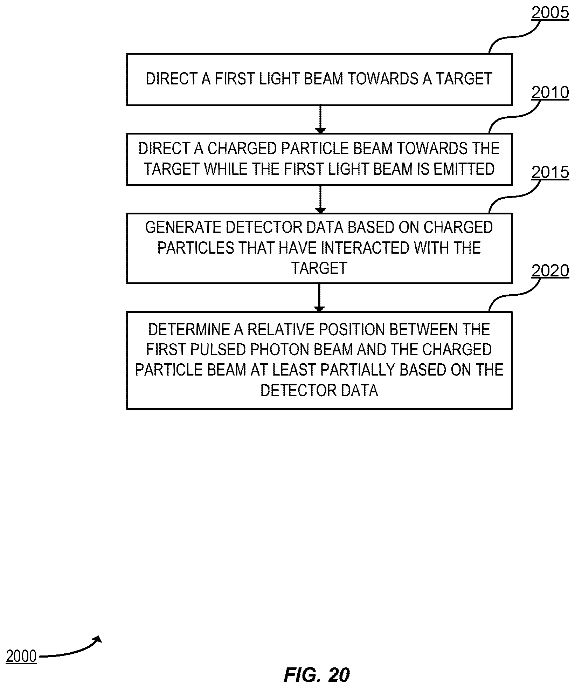

FIG. 20 is an example block flow diagram 2000 illustrating for aligning pulsed charged particle beams and pulsed photon beams, in accordance with embodiments of the present disclosure. In some embodiments, the flow diagram 2000 may include more or fewer steps than the number depicted in FIG. 20. It should be appreciated that the steps of the flow diagram 2000 may be performed in any suitable order. The flow diagram 2000 may be performed by some or all components of systems, devices, and/or include the processes, methods, or techniques as those described in relation to FIGS. 1-19 and 21-26.

The flow diagram 2000 may begin at step 2005, where a light source may direct a first pulsed photon beam towards a target. The light source may include any suitable light source including coherent laser sources, pulsed light sources, continuous light sources, or similar. In some examples, the light source may emit during a duty cycle.

The flow diagram 2000 may continue at step 2010 where a charged particle source may emit a charged particle beam (e.g., electrons, ions, etc.) towards the target while the first pulsed photon beam is emitted. In some examples, the charged particle beam and the first pulsed photon beam are emitted substantially at the same time. In other examples, the charged particle beam may be emitted, or pulsed, before or after the first pulsed photon beam is emitted. The charged particle beam and the first pulsed photon beam may not be spatially aligned at the target initially.

At step 2015, detector data (e.g., image, line image, etc.) may be generated based at least in part on charged particles that have interact with the target and have corresponding energies within an energy range. For example, a detector may construct the first image of the target based at least in part on the charged particle beam interrogating the target. When the charged particle beam interrogates the target, the first pulsed photon beam may impinge on a surface of the target and create an energy gain field (e.g., energy gain field 1652 of FIG. 16) for charged particles to change energy as they interact with the energy gain field.

At step 2020, a position may be determined between the first pulsed photon beam and the charged particle beam at least partially based at least in part on the detector data. For example, switching an energy filter to an EGFTEM mode (e.g., energy filtered mode) to filter charged particles which may have changed energy due to the interaction with the first pulsed photon beam may enable the detector to generate the detector data which may include photon beam spots. By comparing the photon beam spots with locations on the target, the position of the photon beam spot (e.g., the location where the photon beam hits the target) compared to the charged particle beam may be accurately and reliably determined. In addition, or alternatively, a shape profile, a peak fluence, and/or an intensity profile of the photon beam at the target may be determined.

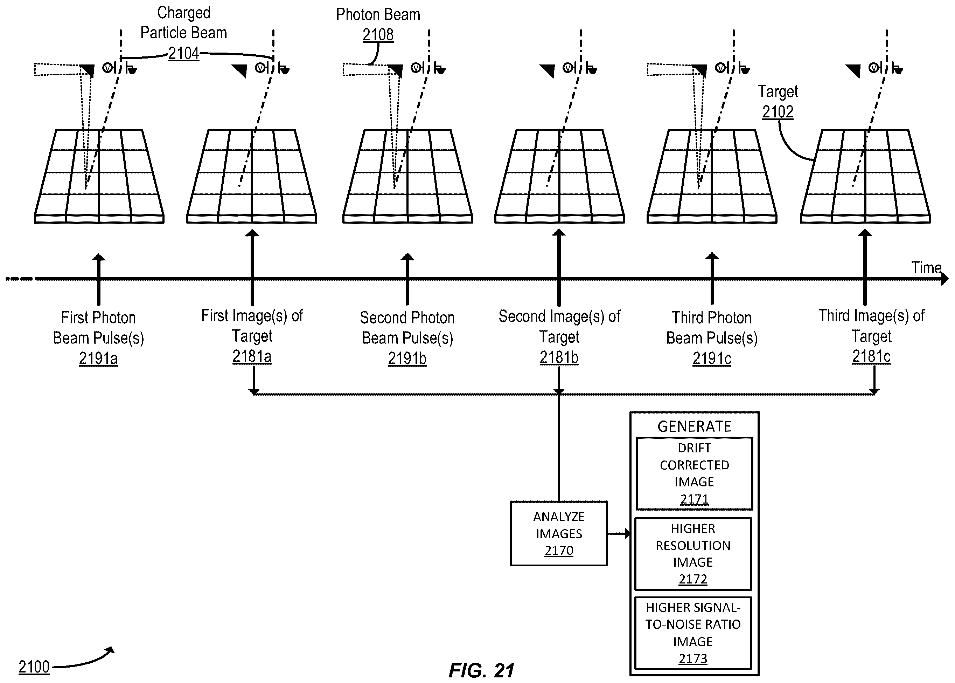

FIG. 21 is an example interrogation process 2100 for correcting target drift during and/or after aligning pulsed charged particle beams and pulsed photon beams, in accordance with embodiments of the present disclosure. In some examples, the process 2100 may be implemented by some or all components of systems, devices, and/or include processes, methods, or techniques as those described in relation to FIGS. 1-20 and 22-26. In some examples, the process 2100 may be used to synchronize a detector (e.g., a fast UFTEM detector) and a beam blanker (e.g., a beam blanker 155 as in FIG. 1) to monitor a target between photon beam pulses. In addition, or alternatively, the target may be monitored prior to, during, and/or after a pulsed photon beam 2108 being aligned with a charged particle beam 2104. While the process 2100 depicts the pulsed photon beams 2108 and the charged particle beams 2104 coinciding at certain intervals, it should be understood that any suitable pulse durations, frequencies, sequences, or similar of the pulsed photon beams 2108 and the charged particle beams 2104 may be implemented. For example, the pulsed photon beams 2108 and the charged particle beams 2104 may have some temporal overlap and/or no temporal overlap while being emitted.

In an example, a first photon beam pulse 2191a may be applied to the target prior to, during, and/or after the charged particle beam 2104 interrogates the target. The first photon beam pulse 2191a may discontinue (e.g., deactivate, blocked, repositioned) after a first time interval (e.g., a few picoseconds (ps)) such that only the charged particle beam 2104 is interrogating the target. During a second time interval (on the order of five microseconds or more) between the first photon beam pulse 2191a and a second photon beam pulse 2191b, a detector (not depicted) may acquire one or more first image(s) 2181a (e.g., from one to a few dozen images) while the target is relaxing (e.g., local area cooling) by using the beam blanker to pulse the charged particle beam 2104 (e.g., stroboscopic pump-probing). In some examples, the photon beam 2108 may be pulsed at a repetition rate of around one hundred kilohertz (kHz) or lower.

According to some embodiments, some or all of the first image(s) 2181a may be analyzed to identify i) a photon beam 2108 position, ii) a charged particle beam 2104 position, iii) a drift vector of the target, iv) an alignment of the photon beam 2108 with the charged particle beam 2104, v) damage to the target, vi) expansion of the target, vii) a change to the target, or combinations thereof. For example, an image processor (e.g., image processor 2424 of FIG. 25) may analyze images 2170 detected by the detector in order to post-process the first image(s) 2181a to generate one or more corrected images that may include i) one or more drift corrected images, ii) one or more higher resolution images 2172, iii) one or more higher signal-to-noise ratio images 2173, or combinations thereof. The image processor may perform these functions by applying one or more operations (e.g., combining, correlation, subtraction, convolution, etc.) to the first image(s) 2181a to determine if the target has expanded, contracted, shifted, or otherwise changed during the experiment. In some examples, when generating the one or more drift corrected images, the image processor may determine a drift vector (e.g., as discussed in more detail in FIG. 22) which may enable a user and/or a controller (e.g., controller 2601 of FIG. 26) to adjust i) a photon beam 2108 position, ii) a charged particle beam 2104 position, iii) a light source position, iv) a target position, v) a stage position which supports the target, or combinations thereof.

In some examples, the process 2100 may repeat over several cycles such that second photon beam pulse(s) 2191b, third photon beam pulse(s) 2191, second image(s) 2181b, and third image(s) 2181c, and so on, are generated. In some examples, the image processor may analyze images from one or more of the first image(s) 2181a, second image(s) 2181b, or third image(s) 2181c collectively. In addition, or alternatively, the image processor may analyze a subset of images based at least in part on user selections or determinations by the controller (e.g., image selection algorithms). In some examples, images may not be captured in between each photon beam pulse.

FIG. 22 is an example imaging process 2200 for correcting target drift before, during, or after aligning pulsed charged particle beams and pulsed photon beams, in accordance with embodiments of the present disclosure. In some examples, the process 2200 may be implemented by some or all components of systems, devices, and/or include processes, methods, or techniques as those described in relation to FIGS. 1-21 and 23-26. In some examples, a photon beam 2108 and a charged particle beam 2204 may be temporally aligned (e.g., as described in more detail in FIG. 4) and spatially aligned (e.g., as described in more detail in FIG. 12) on a target 2202. The target 2202 may include a target structure 2202a which may represent a surface and/or inner topography of the target 2202. A detector may construct (e.g., by communicating with an image processor) one or more first image(s) 2281a of the target 2202 (e.g., image of target structure 2202a) during a first interval between first photon beam pulse(s) 2291a and second photon beam pulse(s) 2191b. In some examples, one or more second photon beam pulse(s) 2291b are generated during a second time interval. After the second time interval, the detector may generate one or more second image(s) of the target 2202. The image processor may analyze the first image(s) 2281a and the second image(s) 2281b to determine one or more drift vector(s) 2273a, 2273b associated with a target drift 2260.

In some examples, the target drift 2260 may be a result of heating, cooling, expansion, contraction, position shifts, distortion, and/or shearing of the target 2202. The target drift 2260 may be identified over observing an apparent motion of one or more identified structures over two or more images captured of the target 2202. For example, if a first target sub-structure 2271a is identified by the image processor in the first image(s) 2181, and the same target sub-structure 2271a is identified in the second image(s) 2281b, but shifted along the drift vector 2273a to a new position where a second target sub-structure 2271b is located. This process of identifying drift vectors 2273a, 2273b in images 2281a, 2281b, 2281c may be used to correct for heating, cooling, expansion, contraction, position shifts, distortion, and/or shearing of the target 2202 during acquisitions.

According to various examples, the process 2200 may include generating a first subset of images during the first subset of time intervals such that the first image is generated by combining the first subset of images. In addition, or alternatively, a first drift vector (e.g., drift vector 2273a) may be obtained by cross-correlating the first subset of images with each other, or with a reference image. The first drift vector may be applied to each image of the first subset of images to generate the first corrected image and a second subset of images during the second subset of time intervals may be generated such that the second image may be generated by combining the second subset of images. In some examples, a second drift vector (e.g., drift vector 2273b) may by cross-correlating the second subset of images. Similar to the first image, the second drift vector may be applied to each image of the second subset of images to generate the second corrected image. The process may be iterated any suitable number of times to achieve a desired acquisition of the target. For example, a third corrected image may be generated by combining the first corrected image and the second corrected image, and/or any additional supplement image, such that the third corrected image may have a higher signal-to-noise ratio than the first corrected image or the second corrected image.

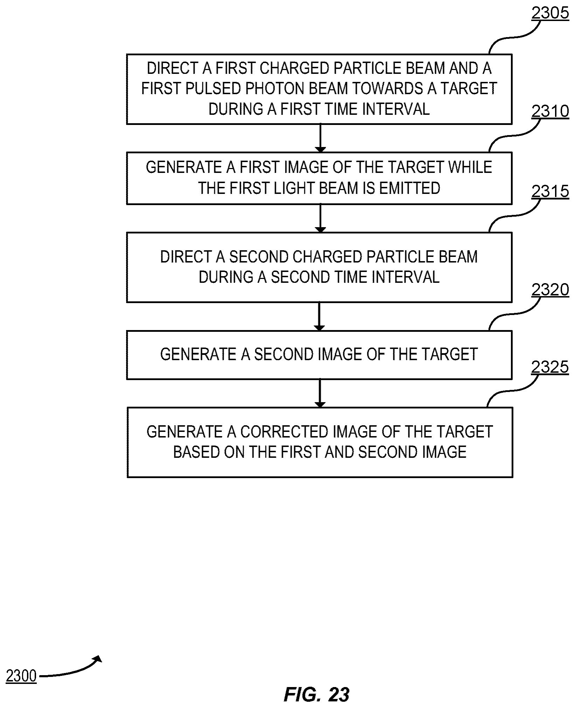

FIG. 23 is an example block flow diagram 2300 illustrating for aligning pulsed charged particle beams and pulsed photon beams, in accordance with embodiments of the present disclosure. In some embodiments, the flow diagram 2300 may include more or fewer steps than the number depicted in FIG. 23. It should be appreciated that the steps of the flow diagram 2300 may be performed in any suitable order. The flow diagram 2300 may be performed by some or all components of systems, devices, and/or include the processes, methods, or techniques as those described in relation to FIGS. 1-22, 24-26.

The flow diagram 2300 may begin at step 2305, where a first charged particle beam and a first pulsed photon beam may be directed towards a target during a first time interval. The first charged particle beam may be emitted by a charged particle source such as an electron source. In some examples, the first photon beam may be emitted by a laser source.

At step 2310, a first image of the target may be generated while the first pulsed photon beam is emitted. For example, the charged particle beam may interact with the target while the first pulsed photon beam impinges on the target. The charged particles relay information, by way of first interactions with portions of the target, about the target to a detector, where the charged particles may pass through an energy filter prior to reaching the detector. The detector may communicate with an image processor (e.g., image processor 2624 of FIG. 26) in order to generate the first image.

At step 2315, the charged particle source may direct a second charged particle beam during a second time interval. In some examples, the first time interval and the second time interval may be non-overlapping intervals. In other examples, the first time interval and the second time interval include a delay and/or overlap by some overlap time. In addition, or alternatively, the second time interval may be equal to or longer than the first time interval.

At step 2320, a second image of the target may be generated of the target based at least in part on second interactions of charged particles from the second charged particle beam. The charged particles relay information, by way of the second interactions with portions of the target, about the target to a detector, where the charged particles may pass through an energy filter prior to reaching the detector. The detector may communicate with the image processor in order to generate the second image.

At step 2325, one or more corrected images may be generated of the target based at least in part on the first and second image. In some examples, the first image may include a first set of images and the second image may include a second set of images. In addition, or alternatively, generating the corrected image may include modifying at least one image of the first set of images with at least one image of the second set of images such that the corrected image may have i) a higher signal-to-noise ratio (SNR) than the first image, ii) a higher signal-to-noise ratio than the second image, iii) a higher resolution than the first image, or iv) a higher resolution than the second image. In various examples, a video of the target may be generated by sequencing images detected by the detector. In addition, or alternatively, the video may be updated with the corrected images.

In some examples, the process may include emitting a third charged particle beam during a reserved time interval (e.g., a time interval where no acquisition was planned) such that the light source does not emit light during the reserved time interval. The reserved time interval may correspond to a total duration of the second additional time intervals and/or any suitable combination of time intervals.

In some examples, one or more reference images may be acquired prior to, during, and/or after the photon beam is pulsed onto the target. The reference images may be an image of the target while relaxed, excited, and/or in a desired state. The reference image may be a series of images updated throughout the experiment. In a non-limiting example, a reference image of the target may be acquired prior to beginning a UFTEM experiment and stored in memory. During the experiment, as discussed above, the photon beam (e.g., laser pulse), hits the target during a first time interval where one or more first images are acquired of the target in the excited state. After the photon beam is deactivated, or otherwise removed from the target, the target begins to cool down and relax back to an unexcited state. During this second time interval of cooling, a train or "set" of alignment images, which may include the second image, may be captured using the charged particle beam. For example, an experiment may include a number of shots (e.g., ten million shots), where sets of alignment images (e.g., periodic sets of ten alignment images for each photon beam pulse) are captured. The set of alignment images may be added up (simple sum), combined, correlated, etc. to obtain and/or otherwise interpolate one or more drift vectors associated with the set of alignment images of the target. Those drift vectors may be applied to the first images in order to correct for target drift by producing an updated second corrected image. The process may be repeated for some and/or each photon beam pulse to provide a "video" of updated and corrected images for any suitable number of photon beam pulses and/or charged particle beam pulses and/or duty cycles for an experiment.

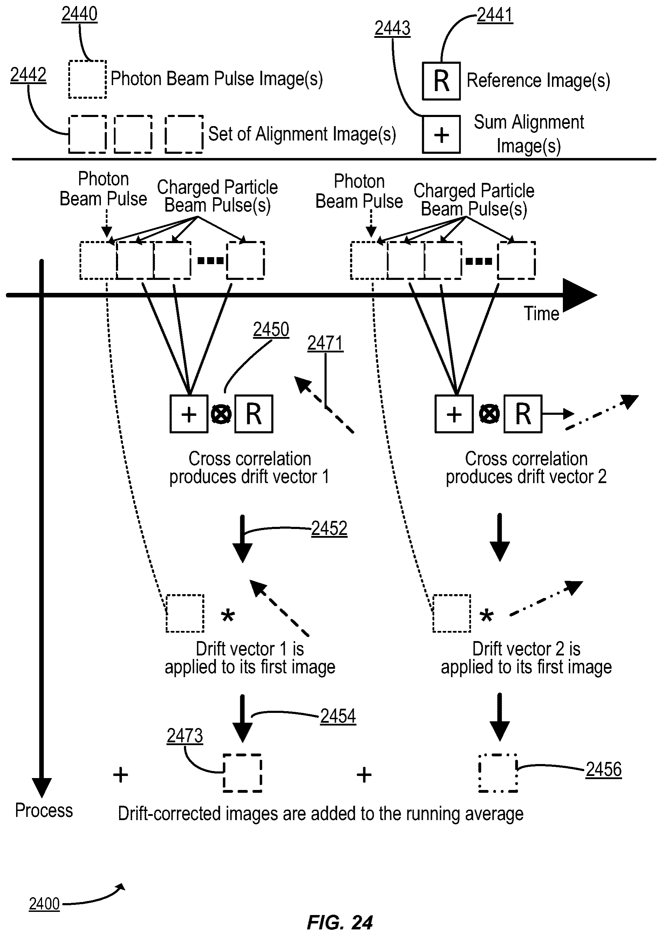

FIG. 24 is an example process 2400 illustrating steps for alignment of a target and/or photon beam during an example experiment as a function of time, according to some embodiments. In some embodiments, the process 2400 may include more or fewer steps than the number depicted in FIG. 24. It should be appreciated that the steps of the process 2400 may be performed in any suitable order. The process 2400 may be performed by some or all components of systems, devices, and/or include the processes, methods, or techniques as those described in relation to FIGS. 1-23, 25, and 26.

The process 2400 may begin prior to, during, and/or after alignment of the pulsed photon beam with the charged particle beam as described above. In addition, or alternatively, the process 2400 may aid in alignment of the pulsed photon beam and the charged particle beam on the target as will be discussed herein. In a non-limiting example, during an experiment a number of images may be captured which may include image(s) 2440 (e.g., first image in step 2310 of FIG. 23) and a set of alignment image(s) (e.g., second image in step 2320 of FIG. 23) 2442 may be captured by a detector. The image(s) 2440 may be images that are captured during a photon beam pulse and a charged particle beam pulse and the set of alignment image(s) 2442 may be images that are captured during a charged particle beam pulse when the pulsed photon beam pulse is inactive or otherwise not impacting the target. Reference image(s) 2441 may be captured prior to, during, or after the experiment. In some examples, the reference image(s) 2441 may include any suitable one or more of the image(s) 2440, set of alignment image(s) 2442, or combinations thereof.

At step 2450, a controller (e.g., controller 2501) may generate a first alignment image 2443 by combining (e.g., simple sum) the set of alignment images 2442. In addition, or alternatively, a first drift vector 2471 may be determined by cross-correlating the first alignment image 2443 with the reference image(s) 2441. The first drift vector 2471 may be representative of the target drift due to expansion, heating, cooling, or combinations thereof. At step 2452, the first drift vector 2471 may be applied to the image(s) 2440 to generate a corrected image 2473.

At step 2454, the corrected image 2473 (e.g., drift corrected image) is stored in memory for retrieval, updates, and/or viewing. In some examples, the process 2400 repeats iteratively such that the corrected image 2473 is updated with a second corrected image 2456. In various examples, the corrected images 2473, 2456, etc. are added to a running average. In addition, or alternatively, the corrected images 2473, 2456, etc. are displayed as a video in a GUI viewable by a user (e.g., updating the video each time additional corrected images are generated).

In some examples, a first sum of the one or more image(s) 2440 may be combined to create one or more first summed image(s) (not depicted) and a second sum of the set of alignment image(s) 2442 (including those generated after multiple photon beam pulses) to generate one or more second summed alignment image(s). The first summed image(s) may then be corrected based at least in part on the second summed alignment image(s). The corrections may be performed by cross-correlating, convolution, or any suitable data/image processing technique.

FIG. 25 is an example block flow diagram 2500 illustrating a process for aligning pulsed charged particle beams and pulsed photon beams, in accordance with embodiments of the present disclosure. In some embodiments, the flow diagram 2500 may include more or fewer steps than the number depicted in FIG. 25. It should be appreciated that the steps of the flow diagram 2500 may be performed in any suitable order. The flow diagram 2500 may be performed by some or all components of systems, devices, and/or include the processes, methods, or techniques as those described in relation to FIGS. 1-24 and 26.

The flow diagram 2500 may begin at step 2505, where a first pulsed photon beam is directed towards a target by a light source. The first pulsed photon beam may hit the target at an unknown location and may be directed by an optical arrangement (e.g., mirrors 1109 of FIG. 11) to one or more positions on the target.

At step 2510, a charged particle source may direct a charged particle beam towards the target while the first photon beam is emitted.

At step 2515, a diffraction pattern (e.g., first diffraction pattern 1240a) may be detected by a detector (e.g., detector 1710 of FIG. 17). The diffraction pattern may result from at least one interaction of the charged particle beam with the target (e.g., as described in more detail in FIG. 12) and include one or more diffraction peaks (e.g., diffraction peak 1358c of FIG. 13).

At step 2520, a second pulsed photon beam may be directed towards the target. For example, the light source may be a pulsed laser source and may emit the second pulsed photon beam according to the direction of light emission controlled by the optical arrangement. In some examples, the second pulsed photon beam is emitted during a second time interval. The second time interval may be less than, greater than, or equal to the first time interval.

At step 2525, a deviation of the diffraction pattern may be determined based at least in part on the second pulsed photon beam interacting with the target. For example, the deviation may include a change in an intensity of the diffraction peak. The deviation may be determined by comparing the diffraction peak when the first pulsed photon beam was emitted against the diffraction peak when the second pulsed photon beam was emitted. In some examples, the diffraction peak may be user selected and/or may be automatically selected by the microscope.

At step 2530, a direction of pulsed photon emission by the light source may be controlled and/or adjusted. For example, the optical arrangement may include mirrors that may change a position of the first pulsed photon beam which hits the target. In some examples, the adjustment may be automatic by the microscope (e.g., controller 2601 of FIG. 26) or may be performed by a user of the microscope.

At step 2535, a third pulsed photon beam may be directed toward the target. For example, the light source may direct the third pulsed photon beam according to the direction of light emission controlled by the optical arrangement. In some examples, the third pulsed photon beam is emitted during a third time interval. The third time interval may be less than, greater than, or equal to the first time interval or second time interval.

At step 2540, detector data (e.g., image, line image, etc.) may be generated based at least in part on charged particles that resulted from a second interaction with the target and the third pulsed photon beam. The third pulsed photon beam may be associated with an energy change. For example, the charged particles may interact with a second energy gain field resulting from the second pulsed photon beam and/or third pulsed photon beam interacting with the target and change energy. As a result, an energy filter (e.g., energy filter 1912) may be configured to selectively filter charged particles which have not gained energy.

At step 2545, a position (e.g., relative position, absolute position, etc.) between the third pulsed photon beam and the charged particle beam may be determined based at least partially on the image. For example, the energy filter may function with the detector and an image processor to generate the image (e.g., EGFTEM image 1960a of FIG. 19) which may include a beam spot profile (e.g., first two dimensional beam profile 1971b of FIG. 19). In addition, or alternatively, the position may be at least partially based at least in part on the deviations in the diffraction pattern (e.g., as discussed in more detail in FIG. 12).

FIG. 26 is an example block diagram 2600 of a controller 2601 for performing methods, processes, techniques, and similar for a microscope system according to certain aspects of the present disclosure. Examples of the microscope system can include some or all components of microscope systems from FIGS. 1-4, 6, 11, 12, 16-19. Examples of the methods, processes, techniques, operations, can include some or all methods, processes, techniques, operations of FIGS. 5, 7-10, 13-15, and 20-25. As shown, the controller 2601 may include a processor 2602 communicatively coupled to memory 2604. The processor 2602 can include one processing device or multiple processing devices. Non-limiting examples of the processor 2602 include a Field-Programmable Gate Array (FPGA), an application specific integrated circuit (ASIC), a microprocessor, or any combination of these. The processor 2602 can execute instructions 2610 stored in the memory 2604 to perform operations, such as the operations of microscopes, processes, scans, and methods of 7-10, 13-15, and 20-25. In some examples, the instructions 2610 can include processor-specific instructions generated by a compiler or an interpreter from code written in any suitable computer-programming language, such as C, C++, C#, Python, or Java.

The memory 2604 can include one memory device or multiple memory devices. The memory 2604 can be non-volatile and may include any type of memory device that retains stored information when powered off. Non-limiting examples of the memory 2604 include electrically erasable and programmable read-only memory (EEPROM), flash memory, or any other type of non-volatile memory. At least some of the memory 2604 can include a non-transitory computer-readable medium from which the processor 2602 can read instructions 2610 via bus 2606. The bus 2606 may be a communication and/or power bus that enables processor 2602 to communicate with memory 2604. The non-transitory computer-readable medium can include electronic, optical, magnetic, or other storage devices capable of providing the processor 2602 with the instructions 2610 or other program code. Non-limiting examples of the non-transitory computer-readable medium include magnetic disk(s), memory chip(s), RAM, an ASIC, or any other medium from which a computer processor can read instructions 2610.

The memory 2604 can further include operation information about parameters 2612 (e.g., calibrations, image capture, detector sensitivity, power), RF cavity chopper 2620 (e.g., frequency, synchronization, calibration), image processor 2624 (e.g., dark field, bright field, calibration, intensity, synchronization), light source 2626 (e.g., duty cycle, pulse frequency, synchronization, alignment, calibration), beam blanker 2622 (e.g., frequency, synchronization, calibration), energy filter settings 2628 (e.g., position, adjustments, calibration), and a target stage 2630 (e.g., position, orientation, translations). The controller 2601 can receive the information about operating parameters from a microscope, such as a TEM, SEM, or similar. At least some of the information about any of the controller 2601 components can be pre-stored and can be associated with a various scanning passes (e.g., acquisitions). The parameters 2612 can include operating parameters associated with an electron microscope system, such as a desired energy/primary energy of an electron beam, an energy spread of an energy loss spectrum, lockup mechanisms, feedback loops, etc. In some examples, some of the parameters 2612 can be compared to the predetermined thresholds (e.g., known arrangements, known sample types, etc.).

### DETAILED EXAMPLE EMBODIMENTS

Examples of the inventive subject matter according to the present disclosure are described in the following paragraphs:
A method for aligning a pulsed laser beam in microscopy, the method may include directing a first pulsed photon beam toward a target, directing a charged particle beam towards the target, determining a diffraction pattern resulting from an interaction of the charged particle beam with the target, directing a second pulsed photon beam towards the target, determining a deviation of the diffraction pattern based at least in part on the second pulsed photon beam. In some embodiments, the method may include controlling, based at least in part on the deviation, a direction of pulsed photon emission by a light source, generating detector data based at least in part on charged particles that result from a second interaction with the target, directing a third pulsed photon beam toward the target, and determining a position of the third pulsed photon beam relative to the charged particle beam using the detector data.

The method according to the previous example, wherein controlling the direction of pulsed photon emission may include determining a range of diffraction peaks of the diffraction pattern for the first pulsed photon beam, selecting a diffraction peak of the range of diffraction peaks, and measuring a first intensity of the diffraction peak when the first pulsed photon beam interacts with the target, In some embodiments, the method may include measuring a second intensity of the diffraction peak when the second pulsed photon beam interacts with the target, and calculating the deviation based at least in part on a comparison of the first intensity to the second intensity.

The method according to any of the previous examples, further comprising generating a first position estimate of the second pulsed photon beam relative to the charged particle beam at the target based at least in part on the deviation, generating a second position estimate of the third pulsed photon beam relative to the charged particle beam at the target based at least in part on the detector data, and wherein the position may be determined based at least in part on a comparison of the first position estimate and the second position estimate.

The method according to any of the previous examples, further comprising directing one or more subsequent pulsed photon beams towards one or more locations on the target, for each location of the one or more locations, capturing one or more diffraction images of one or more subsequent diffraction patterns, and determining, based at least in part on comparing the diffraction images, at least one position of the one or more subsequent photon beams relative to the charged particle beam.

The method according to any of the previous examples, determining, based at least in part on the one or more subsequent diffraction patterns, a temperature profile of the target.

The method according to any of the previous examples, further comprising directing one or more subsequent pulsed photon beams at one or more locations on the target until a fourth pulsed photon beam of the one or more subsequent photon beams is determined to be at a second position in a range of zero micrometers to one hundred micrometers to the charged particle beam at the target.

The method according to any of the previous examples, further comprising determining the deviation of the diffraction pattern based at least in part on the second pulsed photon beam may include determining the deviation of an energy peak of the diffraction pattern based at least in part on the second pulsed photon beam.

A non-transitory computer readable medium having stored thereon computer-readable instructions that, when executed by a processor, cause the processor to perform operations which may include directing a first pulsed photon beam towards a target, directing a charged particle beam towards the target; determining a diffraction pattern resulting from an interaction of the charged particle beam with the target, directing a second pulsed photon beam towards the target, determining a deviation of the diffraction pattern based at least in part on the second pulsed photon beam, and adjusting, based at least in part on the deviation, a direction of pulsed photon emission.

The non-transitory computer readable medium according to any of the previous examples, the deviation includes a change in an intensity of a diffraction peak of the diffraction pattern, and wherein the operations may include in response to determining if the intensity has increased or decreased while the second pulsed photon beam is emitted towards the target, performing at least one of: directing a third pulsed photon beam towards a first location if the intensity has increased, directing the third pulsed photon beam towards a second location if the intensity has decreased, or determining that the second pulsed photon beam is in alignment with the charged particle beam.

The non-transitory computer readable medium according to any of the previous examples, wherein the operations may include redirecting the pulsed photon emission to reduce an intensity of one or more diffraction peaks of the diffraction pattern.

The non-transitory computer readable medium according to any of the previous examples, wherein in response to the deviation being within a threshold, determining that the second pulsed photon beam is aligned with the charged particle beam.

The non-transitory computer readable medium according to any of the previous examples, wherein the operations may include generating a first image of the diffraction pattern while the first pulsed photon beam is being emitted, generating a second image of the diffraction pattern while the second pulsed photon beam is being emitted, comparing the second image to the first image to generate a metric, and determining if one of the first pulsed photon beam or the second pulsed photon beam are in alignment with the charged particle beam at the target based at least in part on the metric.

The non-transitory computer readable medium according to any of the previous examples, the operations may include generating a first image of the diffraction pattern at a first time, generating a second image of the diffraction pattern at a second time, determining an image difference between the first image and the second image, and in response to the image difference being less than a comparison threshold, determining a cooling rate of the target based at least in part on a difference of the first time and the second time.

The non-transitory computer readable medium according to any of the previous examples, wherein after the first pulsed photon beam is no longer being emitted toward the target and before the second pulsed photon beam is emitted, determining a temperature of the target, wherein the cooling rate is further based at least in part on the temperature of the target, and determining a repetition rate for the target based at least in part on the temperature remaining below a temperature threshold, wherein the repetition rate is equal to or less than the cooling rate.

A method for aligning a pulsed laser beam in microscopy may include directing a first pulsed photon beam towards a target, directing a charged particle beam towards the target, generating detector data based at least in part on charged particles that have interacted with the target and that have corresponding energies within an energy range, and determining a position between the first pulsed photon beam and the charged particle beam at least partially based at least in part on the first image.

The method of claim according to any of the previous examples, wherein prior to determining the position, switching an energy filter to an energy filtered mode to filter charged particles that have changed energy due to an interaction with the first pulsed photon beam, an imaging the charged particles which have changed energy, wherein the changed energy is measured relative to a zero loss peak, and in response to imaging, determining the position.

The method according to any of the previous examples, wherein the method may include adjusting an energy threshold of the energy filter, and in response to adjusting the energy threshold of the energy filter, determining a shape profile of the first pulsed photon beam at the target, or an intensity profile of the first pulsed photon beam at the target.

The method according to any of the previous examples, wherein the method may include determining a peak fluence of the first pulsed photon beam based at least in part on the shape profile or the intensity profile.

The method according to any of the previous examples, wherein prior to emitting the first pulsed photon beam, generating a first image of the target using the charged particle beam, after emitting the first pulsed photon beam, forming a second image of the target, and generating a profile image of the first pulsed photon beam by subtracting the first image from the second image.

The method according to any of the previous examples, wherein the method may include directing a direction of a second pulsed photon beam based at least in part on the position of the first pulsed photon beam and the charged particle beam at the target.

A method for flexible beam blanking in ultrafast transmission charged particle microscopy, the method may include directing, during a first time interval, a first charged particle beam and a first pulsed photon beam towards a target, generating a first image of the target based at least in part on first interactions of the first charged particle beam with the target, directing, during a second time interval, a second charged particle beam toward the target, generating a second image of the target based at least in part on second interactions of the second charged particle beam, and generating a corrected image of the target based at least in part on the first and second image.

The method according to any of the previous examples, wherein the first time interval and the second time interval may be non-overlapping such that the first pulsed photon beam is emitted by a light source. In some embodiments, the second image may be generated while no pulsed photon beam is emitted towards or received by the target from the light source.

The method according to any of the previous examples, further including generating the corrected image includes correcting at least one of: a drift associated with the target, a drift associated with a charged particle source, or a position or an orientation of a stage on which the target is supported.

The method according to any of the previous examples, wherein the method may include detecting first charged particles resulting from the first interactions during the first time interval using a detector, detecting second charged particles resulting from the second interactions during the second time interval using the detector. In some embodiments, the detector may be configured to detect a difference between the first charged particles and the second charged particles in a time duration that is shorter than a time between an end of the first time interval and a start of the second time interval.

The method according to any of the previous examples, wherein a state of the target changes from an initial state to an excited state during the first time interval, and wherein the state changes from the excited state to the initial state during the second time interval.

The method according to any of the previous examples, further including detecting expansion or damage of the target may be based at least in part on the first image and second image.

The method according to any of the previous examples, wherein the second interval may include a subset of intervals. The method may further include generating a first group of images during the subset of intervals by pulsing the charged particle beam at the target and determining a drift vector by cross-correlating the first group of images.

A non-transitory computer readable medium having stored thereon computer-readable instructions that, when executed by a processor, cause the processor to perform operations that may include directing, during a first time interval, a first charged particle beam towards a target, directing during the first time interval, a first pulsed photon beam towards the target, generating, by using a detector, a first image of the target based at least in part on first interactions of the first charged particle beam with the target, directing, during a second time interval, a second charged particle beam towards the target, generating, by using the detector, a second image of the target based at least in part on second interactions of the second charged particle beam with the target, and generating a corrected image of the target based at least in part on the first image and the second image.

The non-transitory computer readable medium according to any of the previous examples, wherein the first image may include a first set of images. In addition, or alternatively, the second image may include a second set of images. In some examples, the operations may include generating the corrected image by modifying at least one image of the first set of images with at least one image of the second set of images such that the corrected image has: i) a higher signal-to-noise ratio (SNR) than the first image, ii) a higher signal-to-noise ratio than the second image, iii) a higher resolution than the first image, or iv) a higher resolution than the second image.

The non-transitory computer readable medium according to any of the previous examples, wherein the operations may include generating a video of the target in which the first image may be replaced by the corrected image and updating the video each time additional images are corrected.

The non-transitory computer readable medium according to any of the previous examples, wherein the operations may include generating a set of alignment images during the second time interval such that the second image may be included in the set of alignment images. The operations may include combining the set of alignment images to generate a first alignment image, determining a first drift vector by cross-correlating the first alignment image with a first reference image, generating a second corrected image by applying the first drift vector to the first image, and updating the corrected image with the second corrected image.

The non-transitory computer readable medium according to any of the previous examples, wherein the operations may include directing first additional charged particle beams during corresponding first additional time intervals towards the target, wherein the first additional time intervals occur after the second time interval, directing first additional pulsed photon beams during the corresponding first additional time intervals towards the target, and directing second additional charged particle beams during corresponding second additional time intervals, such that the first additional pulsed photon beams are not emitted during the second additional time intervals. In some examples, the second additional time intervals occur after at least one of the first additional time intervals.

The non-transitory computer readable medium according to any of the previous examples, wherein the operations may include generating one or more additional first images during the first additional time intervals, combining at least a first portion of the one or more additional first images, generating one or more additional second images during the second additional time intervals, combining at least a second portion of the one or more additional second additional time intervals, and generating one or more additional corrected images based at least in part on applying the second additional images to the first additional images.

The non-transitory computer readable medium according to any of the previous examples, wherein the operations may include directing a third charged particle beam during a reserved time interval such that a light source does not emit light during the reserved time interval. In some examples, the reserved time interval may correspond to a total duration of the second additional time intervals. The operations may include generating, by using the detector, a third image of the target based at least in part on third interactions of the third charged particle beam with the target such that the corrected image of the target may be further based at least in part on the third image.

A device may include a charged particle beam source configured to direct a first charged particle beam towards a target during a first time interval and a second charged particle beam towards the target during a second time interval. The device may include a light source configured to direct a pulsed photon beam during the first time interval towards the target, a detector configured to detect first charged particles resulting from first interactions with the target and the first charged particle beam and detect second charged particles resulting from second interactions with the target and the second charged particle beam, and a processor configured to generate a first image of the target based at least in part on the first charged particles, generate a second image of the target based at least in part on the second charged particles, and generate a corrected image based at least in part on the first image and second image.

The device according to according to any of the previous examples, a beam blanker may be configured to pulse the second charged particle beam during the second time interval. In some examples, the processor may be configured to control the light source such that no light emission occurs during the second time interval.

The device according to according to any of the previous examples, the beam blanker may be configured to be synchronized with the light source for stroboscopic pump probing.

The device according to according to any of the previous examples, the processor may be configured to generate the corrected image during additional time intervals such that the additional time intervals occur after the second time interval with a repetition rate less than or equal to one hundred kHz.

The device according to according to any of the previous examples, the first image may be generated independently of the second charged particle beam.

The device according to according to any of the previous examples, the second time interval may be equal to or longer than the first time interval.

A charged particle beam system may include a source of charged particles, a charged particle beam column, operably coupled with the source of charged particles and including multiple charged particle optical elements disposed along a beam axis, the charged particle optical elements may include a radio-frequency (RF) cavity. In some examples, the system may include a sample section, operably coupled with the charged particle beam column and defining a sample position on the beam axis, a light beam source, optically coupled with the sample section and may be configured to direct a light beam toward the sample position, and control circuitry, operably coupled with the RF cavity and with the light beam source, and one or more machine-readable storage media, operably coupled with the control circuitry, the media storing executable instructions that, when executed, cause the system to perform operations including those of the methods or media according to embodiments herein.

A method for synchronizing a pulsed charged particle beam with a pulsed light beam, according to any of the previous examples. The method can include synchronizing an RF signal and an optical pulse signal. The method can include generating composite signals using the RF signal, the optical pulse signal, and a reference signal. The method can also include synchronizing the composite signals.

The method according to any of the previous examples, wherein the RF signal describes a frequency generated by an action of an RF cavity on a beam of electrons. The action of the RF cavity on the beam of electrons can include sweeping the beam of electrons across an aperture placed in a path of the beam of electrons. A pulse frequency of the optical pulse signal can be from about 25 MHz to about 125 MHz.

The method according to any of the previous examples, wherein the RF signal and the optical pulse signal are frequency-matched. Frequency matched signals can correspond to a condition wherein a first harmonic frequency of the RF signal is substantially equal to a first harmonic frequency of the optical pulse signal.

The method according to any of the previous examples, further comprising synchronizing the RF signal and the optical pulse signal include generating an error signal using a first harmonic frequency component of the RF signal and a first harmonic frequency component of the optical pulse signal. Synchronizing the RF signal and the optical pulse signal can also include modifying one or more parameters of a pulsed light beam source, as part of an optimization of the error signal. Generating the error signal can include generating a vector-product of the RF signal and the optical pulse signal and filtering the vector-product to remove high frequency components of the vector-product. The high frequency components can include harmonic frequencies higher than the fundamental frequency component.

The method according to any of the previous examples, wherein the pulsed light beam source is a pulsed laser source. The one or more parameters can include a characteristic length of a laser oscillator of the pulsed laser source. The characteristic length can describe a path length of the oscillator between two reflectors, with one or more of the reflectors being movable relative to a gain medium.

The method according to any of the previous examples, further comprising generating the composite signals includes generating an RF composite signal, using a vector-product of a harmonic frequency component of the RF signal and the reference signal and generating an optical composite signal, using a vector-product of a harmonic frequency component of the optical pulse signal and the reference signal. The harmonic frequency can refer to a harmonic order higher than the first, or fundamental, frequency. Generating the optical composite signal can include adding a time delay to the vector-product of the harmonic frequency component of the optical pulse signal and the reference signal. The time delay can be a variable time delay.

The method according to any of the previous examples, wherein the reference signal has a frequency from about 5 MHz to about 50 MHz. Optionally, the frequency can be about 20 MHz.

The method according to any of the previous examples, further comprising synchronizing the composite signals includes generating an error signal using the composite signals. Synchronizing the composite signals can also include modifying one or more parameters of a pulsed light beam source, as part of an optimization of the error signal. Generating the error signal can include generating a vector-product of the RF composite signal and the optical composite signal and filtering the vector-product to remove frequency components of the vector-product outside a passband including the harmonic frequency component of the optical pulse signal and the harmonic frequency component of the RF composite signal.

One or more machine-readable storage media store executable instructions that, when executed by a machine, cause the machine to perform operations including those of the methods according to any of the previous examples.

A charged particle beam system includes a source of charged particles. The system includes a charged particle beam column, operably coupled with the source of charged particles and including multiple charged particle optical elements disposed along a beam axis, the charged particle optical elements including a radio-frequency (RF) cavity. The system includes a sample section, operably coupled with the charged particle beam column and defining a sample position on the beam axis. The system includes a light beam source, optically coupled with the sample section and configured to direct a light beam toward the sample position. The system includes control circuitry, operably coupled with the RF cavity and with the light beam source. The system can also include one or more machine-readable storage media, operably coupled with the control circuitry, the media storing executable instructions that, when executed, cause the system to perform operations including those of the methods of the first aspect in one or more embodiments.

The system according to any of the previous examples, wherein the RF cavity is a dual mode cavity. The RF cavity can include a pickup antenna. The charged particle beam system can include an electron microscope. The electron microscope can be a transmission electron microscope (TEM).

A method for synchronizing a pulsed charged particle beam with a pulsed light beam. The method can include generating a trigger signal. The method can include generating a blanking signal using the trigger signal. The method can also include modulating a beam blanker using the blanking signal.

The method according to any of the previous examples, further comprising generating the trigger signal includes communicating a pulse signal from a pulsed light beam controller to a delay generator. Generating the trigger signal can include receiving a control signal including timing information for the beam blanker and for a pulsed light beam controller. Modulating the beam blanker can include temporarily quenching an electromagnetic field applied by the beam blanker, in the presence of which electrons are deflected away from a beam axis.

The method according to any of the previous examples, further comprising generating the blanking signal includes combining the trigger signal with a delay offset. Generating the blanking signal can include receiving the delay offset from a control system. The delay offset can be an element in a set of offset data. Generating the blanking signal can include selecting the delay offset from the set of offset data in accordance with a process for interrogating a dynamic system.

The method according to any of the previous examples, wherein the trigger signal is characterized by a frequency from about 0.1 kHz to about ten MHz. The method can include synchronizing the pulsed charged particle beam and the pulsed light beam by operations including synchronizing an RF signal and an optical pulse signal, generating composite signals using the RF signal, the optical pulse signal, and a reference signal, and synchronizing the composite signals.

The method according to any of the previous examples, wherein modulating the beam blanker temporarily unblocks the pulsed charged particle beam, permitting one or more pulses of electrons to pass the beam blanker substantially without deflection.

The method according to any of the previous examples, further comprising generating a pulse of photons using a pulsed light beam source, concurrent with generating the trigger signal. The pulsed light beam can be a pulsed laser. The beam blanker can be an electrostatic beam blanker.

One or more machine-readable storage media, storing executable instructions that, when executed by a machine, cause the machine to perform operations including those of the methods according to any of the previous examples.

A charged particle beam system, may include a source of charged particles. The system includes a charged particle beam column, operably coupled with the source of charged particles and including multiple charged particle optical elements disposed along a beam axis, the charged particle optical elements including a radio-frequency (RF) cavity and a beam blanker. The system includes a sample section, operably coupled with the charged particle beam column and defining a sample position on the beam axis. The system includes a light beam source, optically coupled with the sample section and configured to direct a light beam toward the sample position. The system includes control circuitry, operably coupled with the RF cavity and with the light beam source. The system can also include one or more machine-readable storage media, operably coupled with the control circuitry, the media storing executable instructions that, when executed, cause the system to perform operations including those of the methods of the fourth aspect in one or more embodiments.

The system according to any of the previous examples, wherein the charged particle beam system is an electron microscope. The electron microscope can be a transmission electron microscope (TEM). The beam blanker can be an electrostatic beam blanker.

A method for sampling a pulsed light beam comprising directing a light beam to cross a beam axis of a charged particle beam system. The method can include generating a charged particle beam, the beam being substantially aligned with the beam axis. The method can include directing the charged particle beam into an energy-dispersive spectrometer configured to generate detector data describing an energy distribution of the charged particle beam. The method can also include generating a set of detector data, describing a plurality of energy distributions for a corresponding plurality of timesteps.

The method according to any of the previous examples, wherein the charged particle beam is a pulsed beam and the light beam is a pulsed beam. The method can include synchronizing the charged particle beam with the light beam. The method can also include defining the plurality of timesteps, where a timestep of the plurality of time steps can describe a temporal offset or phase delay of the charged particle beam relative to the light beam.

The method according to any of the previous examples, wherein the light beam includes a pulse of photons defining a temporal profile. The method can include generating profile data using the set of detector data, the profile data describing the temporal profile. Generating the set of detector data can include sampling detector data generated concurrent with a period of interaction of the pulse of photons and the charged particle beam. The detector data can be characterized by a sampling period about an order of magnitude smaller than a pulse duration described by the temporal profile. The method can include generating an operating parameter scheme corresponding to the temporal profile, the operating parameter scheme describing one or more operating parameters of the charged particle beam system.

The method according to any of the previous examples, wherein the charged particle beam includes a pulse of charged particles. Generating the set of detector data can include integrating detector data for a given time step using multiple pulses of charged particles. The charged particles can be electrons. Directing the light beam to cross the beam axis can include coupling the light beam into an optically conducting material, the material being at least partially transmissive to the charged particles. The material can be disposed at least partially on the beam axis. The optically conducting material can include a photonic nanostructure, microresonator, or a photonic metamaterial.

The method according to any of the previous examples, wherein the charged particle beam system is an electron microscope. The electron microscope can be a transmission electron microscope (TEM). The electron microscope can include a radio frequency (RF) cavity, configured to generate a pulsed charged particle beam having a pulse frequency from about twenty five MHz to about one hundred MHz. Optionally, the pulse frequency can be about 75 MHz.

One or more machine-readable storage media, storing executable instructions that, when executed by a machine, cause the machine to perform operations including those of the method according to any of the previous examples.

A charged particle beam system comprises a source of charged particles. The system includes a charged particle beam column, operably coupled with the source of charged particles and including multiple charged particle optical elements disposed along a beam axis, the charged particle optical elements including a radio-frequency (RF) cavity and a beam blanker. The system includes a sample section, operably coupled with the charged particle beam column and defining a sample position on the beam axis. The system includes a light beam source, optically coupled with the sample section and configured to direct a light beam toward the sample position. The system includes control circuitry, operably coupled with the RF cavity and with the light beam source. The system can also include one or more machine-readable storage media, operably coupled with the control circuitry, the media storing executable instructions that, when executed, cause the system to perform operations including those of the methods of the seventh aspect in one or more embodiments.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on ultrafast charged particle beam systems, and ultrafast TEM (or UTEM) systems in particular, these are meant as non-limiting, illustrative embodiments. Embodiments of the present disclosure are not limited to such embodiments, but rather are intended to address analytical instruments systems for which a wide array of material samples can be analyzed to determine chemical, biological, physical, structural, or other properties, among other aspects, including but not limited to chemical structure, trace element composition, or the like, that exhibit temporal dynamics on the sub-microsecond timescale.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on electron microscopy systems, these are meant as non-limiting, illustrative embodiments. Embodiments of the present disclosure are not limited to such materials, but rather are intended to address electron beam systems for which a wide array of particles can be applied to imaging, microanalysis, and/or processing of materials on an atomic scale. Such particles may include, but are not limited to, electrons, ions, or photons in TEM systems, SEM systems, STEM systems, UFTEM systems, EFTEM systems, ion beam systems, and/or particle accelerator systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein, including, for example, methods, operations, processes of FIG. 5, 7-10, 13-15, and 20-25.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

As used in this application and in the claims, the singular forms "a", "an", and "the" include the plural forms unless the context clearly dictates otherwise. Additionally, the term "includes" means "comprises". Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

In some examples, values, procedures, or apparatuses are referred to as "lowest", "best", "minimum", "greater", "less than", "equal to" or the like. It will be appreciated that such descriptions are intended to indicate that a selection among many used functional alternatives can be made, and such selections need not be better, smaller, or otherwise preferable to other selections.

The term "image" is intended to comprise a two-dimensional grid, wherein the two-dimensional grid can comprise at least one or a plurality of portions. Each portion is characterized by its coordinates and its value (color and/or intensity). Thus, the image may refer to a visual representation of the sample in gray level variations and/or color variations and/or intensity variations. Further, each portion in the image may correspond to a point (e.g. location) on the target or a sublocation on the target, or similar.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±20%. For example, a dimension of "about 20 mm" can describe a dimension from fifteen mm to twenty five mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A method for aligning a pulsed laser beam in microscopy, the method comprising:
directing a first pulsed photon beam towards a target;
directing a charged particle beam towards the target;
determining a diffraction pattern resulting from an interaction of the charged particle beam with the target;
directing a second pulsed photon beam towards the target;
determining a deviation of the diffraction pattern based at least in part on the second pulsed photon beam;
controlling, based at least in part on the deviation, a direction of pulsed photon emission by a light source;
directing a third pulsed photon beam toward the target;
generating detector data based at least in part on charged particles that result from a second interaction with the target and the third pulsed photon beam; and
determining a position of the third pulsed photon beam, relative to the charged particle beam using the detector data.

2. The method of claim 1, wherein controlling the direction of pulsed photon emission further comprises:
determining a range of diffraction peaks of the diffraction pattern for the first pulsed photon beam;
selecting a diffraction peak from the range of diffraction peaks;
measuring a first intensity of the diffraction peak when the first pulsed photon beam interacts with the target;
measuring a second intensity of the diffraction peak when the second pulsed photon beam interacts with the target; and
calculating the deviation based at least in part on a comparison of the first intensity to the second intensity.

3. The method of any of claims 1 to 2, further comprising:
generating a first position estimate of the second pulsed photon beam relative to the charged particle beam at the target based at least in part on the deviation; and
generating a second position estimate of the third pulsed photon beam relative to the charged particle beam at the target based at least in part on the detector data, wherein the position is determined based at least in part on a comparison of the first position estimate and the second position estimate.

4. The method of any of claims 1 to 3, further comprising:
directing one or more subsequent pulsed photon beams towards one or more locations on the target;
for each location of the one or more locations, capturing one or more diffraction images of one or more subsequent diffraction patterns; and
determining, based at least in part on comparing the diffraction images, at least one position of the one or more subsequent photon beams relative to the charged particle beam.

5. The method of claim 4, determining, based at least in part on the one or more subsequent diffraction patterns, a temperature profile of the target.

6. The method of any of claims 1 to 5, further comprising:
directing one or more subsequent pulsed photon beams at one or more locations on the target until a fourth pulsed photon beam of the one or more subsequent photon beams is determined to be at a second position in a range of 0 micrometers to 100 micrometers to the charged particle beam at the target.

7. The method of any of claims 1 to 6, wherein determining the deviation of the diffraction pattern based at least in part on the second pulsed photon beam comprises:
determining the deviation of an energy peak of the diffraction pattern based at least in part on the second pulsed photon beam.

8. A computer program product comprising instructions which, when the program is executed by a computer, cause the computer to carry out the steps of the method of any of claims 1 to 7.

9. The computer program product of claim 8, wherein the deviation includes a change in an intensity of a diffraction peak of the diffraction pattern, and wherein the steps further comprise:
in response to determining if the intensity has increased or decreased while the second pulsed photon beam is emitted towards the target, performing at least one of:
directing a third pulsed photon beam towards a first location if the intensity has increased;
directing the third pulsed photon beam towards a second location if the intensity has decreased; or
determining that the second pulsed photon beam is in alignment with the charged particle beam.

10. The computer program product of any of claims 8 or 9, wherein the steps further comprise:
redirecting the pulsed photon emission to reduce an intensity of one or more diffraction peaks of the diffraction pattern.

11. The computer program product of any of claims 8 to 10, wherein the steps further comprise:
in response to the deviation being within a threshold, determining that the second pulsed photon beam is aligned with the charged particle beam.

12. The computer program product of any of claims 8 to 11, wherein the steps further comprise:
generating a first image of the diffraction pattern while the first pulsed photon beam is being emitted;
generating a second image of the diffraction pattern while the second pulsed photon beam is being emitted;
comparing the second image to the first image to generate a metric; and
determining if one of the first pulsed photon beam or the second pulsed photon beam are in alignment with the charged particle beam at the target based at least in part on the metric.

13. The computer program product of any of claims 8 to 12, wherein the steps further comprise:
generating a first image of the diffraction pattern at a first time;
generating a second image of the diffraction pattern at a second time;
determining an image difference between the first image and the second image; and
in response to the image difference being less than a comparison threshold, determining a cooling rate of the target based at least in part on a difference of the first time and the second time.

14. The computer program product of claim 13, wherein the steps further comprise:
after the first pulsed photon beam is no longer being emitted toward the target and before the second pulsed photon beam is emitted, determining a temperature of the target, wherein the cooling rate is further based at least in part on the temperature of the target; and
determining a repetition rate for the target based at least in part on the temperature remaining below a temperature threshold, wherein the repetition rate is equal to or less than the cooling rate.
